Europäisches Patentamt

European Patent Office

Office européen des brevets

(19)

(11) **EP 0 689 723 B1**

(12) **EUROPÄISCHE PATENTSCHRIFT**

(45) Veröffentlichungstag und Bekanntmachung des Hinweises auf die Patenterteilung:
**04.06.1997 Patentblatt 1997/23**

(21) Anmeldenummer: **94909122.7**

(22) Anmeldetag: **08.03.1994**

(51) Int Cl.6: **H01L 43/06**

(86) Internationale Anmeldenummer:
**PCT/EP94/00701**

(87) Internationale Veröffentlichungsnummer:
**WO 94/20993 (15.09.1994 Gazette 1994/21)**

(54) **HALLEFFEKT-EINRICHTUNG MIT STROM- UND HALLSPANNUNGS-ANSCHLÜSSEN**

HALL-EFFECT DEVICE WITH CURRENT AND HALL-VOLTAGE CONNECTION POINTS

DISPOSITIF A EFFET HALL COMPORTANT DES POINTS RACCORDEMENT DE COURANT ELECTRIQUE ET DE TENSION DE HALL

(84) Benannte Vertragsstaaten:
**CH DE ES FR GB LI**

(30) Priorität: **08.03.1993 DE 4307249**
**16.03.1993 DE 4308375**

(43) Veröffentlichungstag der Anmeldung:
**03.01.1996 Patentblatt 1996/01**

(73) Patentinhaber: **Max-Planck-Gesellschaft zur Förderung der Wissenschaften e.V. Berlin 80539 München (DE)**

(72) Erfinder:
• **MANI, Ramesh, G.**
**D-70176 Stuttgart (DE)**
• **VON KLITZING, Klaus**
**D-70563 Stuttgart (DE)**

(74) Vertreter: **Heusler, Wolfgang, Dipl.-Ing. et al Dr. Dieter von Bezold Dipl.-Ing. Peter Schütz Dipl.-Ing. Wolfgang Heusler Brienner Strasse 52 80333 München (DE)**

(56) Entgegenhaltungen:
**EP-A- 0 148 330**

## Beschreibung

Die vorliegende Erfindung betrifft Halleffekt-Einrichtungen mit einem Hallplättchen oder Hallelement, das mit Stromanschlüssen und Hallspannungsanschlüssen kontaktiert ist. Halleffekteinrichtungen der hier interessierenden Art werden auch als Hall-Generatoren oder Hall-Sonden bezeichnet.

Bringt man einen in seiner Längsrichtung von einem Strom I durchflossenen streifenförmigen, im Vergleich zu seiner Breite dünnen elektrischen Leiter ("Hallelement") in ein Magnetfeld, das eine auf der Leiterebene senkrecht stehende Komponente mit der magnetischen Feldstärke B* aufweist, so entsteht aufgrund des sogenannten Halleffektes zwischen den seitlichen Rändern des streifenförmigen Leiters eine Spannung, die sogenannte Hall-Spannung

$$U_H = A_H \cdot I \cdot B^*/d \qquad (1)$$

wobei $A_H$ der Hall-Koeffizient

$$A_H = r/(n \cdot e) \qquad (2)$$

ist. Hierin bedeuten

B* = magnetische Feldstärke,
d = Dicke des Leiters,
r = von der Beweglichkeit der Ladungsträger abhängiger Faktor,
n = Dichte der Ladungsträger,
e = Elementarladung.

Der Hall-Effekt wird in der Wissenschaft und Technik für die verschiedensten Zwecke nutzbar gemacht, z.B. für robuste Magnetometer, magnetfeldbetätigte Schalter, Positionssensoren und neuerdings auch für hochpräzise Widerstandsstandards, bei dem der Quanten-Halleffekt ausgenutzt wird, siehe z.B. die Veröffentlichungen von Kordi¿ in "Sensors and Actuators", **10** (1986) 347-378 und von Popovi¿ in "Sensors and Actuators" **17**, (1989) 39-53.

Im einfachsten Falle enthält eine Halleffekt-Einrichtung (Hall-Generator) einen möglichst dünnen, rechteckigen oder streifenförmigen elektrischen Leiter ("Hallplatte" oder "Hallelement"), der mit vier elektrischen Anschlüssen versehen ist und üblicherweise aus einem Halbleitermaterial, wie z.B. Si, Ge, GaAs, Bi etc. besteht.

Aufgrund der Gleichung (1) könnte man annehmen, daß die Empfindlichkeit einer Halleffekt-Einrichtung, also das Verhältnis von Hallspannung zu magnetischer Feldstärke, durch Erhöhung des Stromes I beliebig gesteigert werden könnte. In der Praxis zeigt es sich jedoch, daß durch Störeffekte, insbesondere mangelhafte Ausrichtung der Anschlüsse (Positionsfehler) und Inhomogenitäten des Leitermaterials sehr schnell eine Grenze erreicht wird, da diese Unvollkommenheiten einen widerstandsbedingten Spannungsabfall und damit auch ohne Einwirkung eines Magnetfeldes eine Fehlerspannung (Offset-Spannung) an den Hallspannungsanschlüssen verursachen. Wenn die Hallspannung bei schwachen Magnetfeldern in die Größenordnung dieser Fehlerspannungen gelangt, ist eine ordnungsgemäße Messung offensichtlich nicht mehr gewährleistet.

Es sind bereits verschiedene Maßnahmen zur Beseitigung oder Kompensation dieser Fehlerspannungen bekannt. Das einfachste Verfahren besteht darin, das Signal an den Hallspannungsanschlüssen bei zwei entgegengesetzten Richtungen des Magnetfeldes zu messen, wobei dann die Fehlerspannung durch Subtraktion der gewonnenen Signale eliminiert werden kann. In der Praxis ist eine Umkehr der Magnetfeldrichtung jedoch meist sehr schwer durchführbar. Ein anderes, etwas komplizierteres Verfahren arbeitet mit einem Austausch der Stromanschlüsse und der Hallspannungs-Anschlüsse ohne Feldumkehr. Hier werden außer einer Bildung der Signaldifferenz relativ komplizierte Umschalter benötigt. Schließlich ist es bekannt, die Fehlerspannungen durch Verwendung gegeneinandergeschalteter, gepaarter Halleffekt-Einrichtungen zu kompensieren. Es ist jedoch wegen der praktisch unvermeidlichen Materialinhomogenitäten kaum möglich, genau gleiche Hallelemente herzustellen, auch wenn diese auf dem gleichen Substrat gebildet werden. Außerdem benötigen solche Anordnungen die doppelte Fläche und Leistung.

Für manche Anwendungen, wie z. B. die Messung von örtlich veränderlichen Magnetfelder, wie Gradientenfeldern, werden ebenfalls bessere, insbesondere einfachere, genauere und funktionstüchtigere Halleffekt-Einrichtungen benötigt.

Der vorliegenden Erfindung liegt ausgehend von diesem Stand der Technik in erster Linie die Aufgabe zugrunde, Halleffekt-Einrichtungen mit neuartigen Konfigurationen anzugeben, mit denen die oben erwähnten widerstandsbedingten Fehlerspannungen auf einfache Weise vermieden und andere Meßaufgaben gelöst werden können.

Ferner liegt der Erfindung die Aufgabe zugrunde, neuartige Halleffekt-Einrichtungen anzugeben, die neue Merkmale aufweisen und neue Anwendungen ermöglichen oder bekannte Aufgaben besser lösen als die bisher bekannten Halleffekt-Einrichtungen.

Die vorliegende Erfindung beruht auf der Entdeckung, daß Halleffekt-Einrichtungen auch mit einem Hallelement realisiert werden können, das mindestens ein jeweils durch einen inneren Rand begrenztes Loch oder Fenster aufweist.

Das Hallelement hat also mathematisch gesprochen die Form eines mehrfach zusammenhängenden Gebietes, im einfachsten Falle die Form eines zweifach zusammenhängenden Gebietes, d. h. daß daß es geschlossene Kurven im Gebiet gibt, die nur mit ein- bzw. mehrmaligem Überschreiten eines Randes zu einem Punkt zusammengezogen werden können.

Ein weiterer Aspekt der vorliegenden Erfindung besteht darin, daß die Randbedingungen durch Injektion von mehr als einem Strom in das Hallelement geändert werden können.

Eine bevorzugte zweifach zusammenhängende Konfiguration ist die eines rechteckigen Rahmens, der durch einen äußeren und einen inneren Rand begrenzt ist. Hier können Ströme jeweils an zwei einander entgegengesetzten Stellen des äußeren und des inneren Randes in das rahmenförmige Hallelement injiziert werden und Hallspannungen können an zwei einander entgegengesetzten Stellen des äußeren und/oder des inneren Randes abgenommen werden. Die injizierten Ströme können unabhängig voneinander so eingestellt werden, daß der resultierende Strom in der Nähe der Hallspannungsanschlüsse verschwindet. Dadurch kann auch kein Spannungsabfall im Bereich der Hallspannungsanschlüsse und damit auch keine widerstandsbedingte Fehlerspannung (Offset-Spannung) auftreten.

Mit einem Hallelement, das mehrere, in einer Reihe oder beliebig über einen Flächenbereich verteilte Löcher oder Fenster aufweist, können örtliche Magnetfeldverteilungen gemessen werden. Am Innenrand jedes Fensters kann ein Strom injiziert und eine Hallspannung abgenommen werden und die Fehlerspannungskompensation kann mittels eines gemeinsamen Stromes erfolgen, der am äußeren Rand injiziert wird.

Die vorliegenden Halleffekt-Einrichtungen zeichnen sich dementsprechend durch eine vielseitige Verwendbarkeit aus. Die Verlustleistung und dementsprechend das thermische Rauschen sind niedrig; die Empfindlichkeit ist mindestens zwei Größenordnungen höher als die vergleichbarer Halleffekt-Einrichtung und wegen der Ausschaltung der widerstandsbedingten Störspannungen ist auch die Temperaturabhängigkeit des Hallspannungssignals klein.

Die Erfindung soll nun unter Bezugnahme auf die Zeichnungen näher erläutert werden, dabei werden noch weitere Vorteile und Merkmale der Erfindung zur Sprache kommen. Es zeigen:

Fig. 1a      eine schematische Darstellung einer Halleffekt-Einrichtung gemäß einer ersten Ausführungsform der Erfindung;

Fig. 1b      eine schematische Darstellung einer zweiten Ausführungsform der Erfindung;

Fig. 2      eine schematische Darstellung einer störspannungskompensierten Halleffekt-Einrichtung gemäß einer dritten Ausführungsform der Erfindung mit einer Stromversorgungsschaltung, die zwei getrennte Stromquellen enthält;

Fig. 3a bis 3f      Diagramme zur Erläuterung der Arbeitsweise der Einrichtung gemäß Fig. 2 und

Fig. 4 bis 24      weitere Ausführungsbeispiele von Halleffekt-Einrichtungen gemäß der Erfindung.

Alle erfindungsgemäßen Halleffekt-Einrichtungen enthalten eine Hallplatte oder ein Hallelement, mindestens ein Paar von Stromanschlüssen und mindestens ein Paar von Hallspannungsanschlüssen. Bei manchen Ausführungsformen kann jedoch ein Stromanschluß auch zur Abnahme einer Hallspannung verwendet werden, so daß dann Strom- und Hallspannungs-anschlüsse zusammenfallen. Das Hallspannungselement ist im allgemeinen ein flächiger Körper, dessen Dicke im Vergleich zu seiner Breite möglichst klein sein soll, also die Form einer dünnen Schicht haben kann. Es kann einen Teil einer integrierten Schaltung bilden, siehe die oben erwähnte Veröffentlichung von Kordic. Für das Hallelement werden Materialien mit geringer Trägerdichte bevorzugt, also insbesondere Halbleitermaterialien wie Silicium, Germanium, $A_{III}B_V$-Verbindungen, wie GaAs, Bismuth etc. wie dem Fachmann bekannt ist.

Das Hallelement kann in üblicher Weise ausgebildet sein. Eine praktisch zweidimensionale leitende "Elektronengas"-Schicht (Dicke ca. 10 nm) liefern bestimmte epitaktische Heterostrukturen, z. B GaAs auf AlGaAs. Die Ladungsträgerdichte beträgt in diesem Fall ca $10^{11} cm^{-2}$. Das Hallelement kann auch aus einer dünnen (z. B. 2 μm dicken) dotierten Siliciumschicht (Trägerdichte etwa $10^{18} cm^{-3}$) bestehen.

Bei allen Halleffekteinrichtungen, die im Folgenden beschrieben werden, wirkt im Betrieb auf das Hallelement ein Magnetfeld ein, das auf der Ebene des Hallelements senkrecht steht oder zumindest eine auf der Ebene des Hallelements senkrecht stehende Komponente hat.

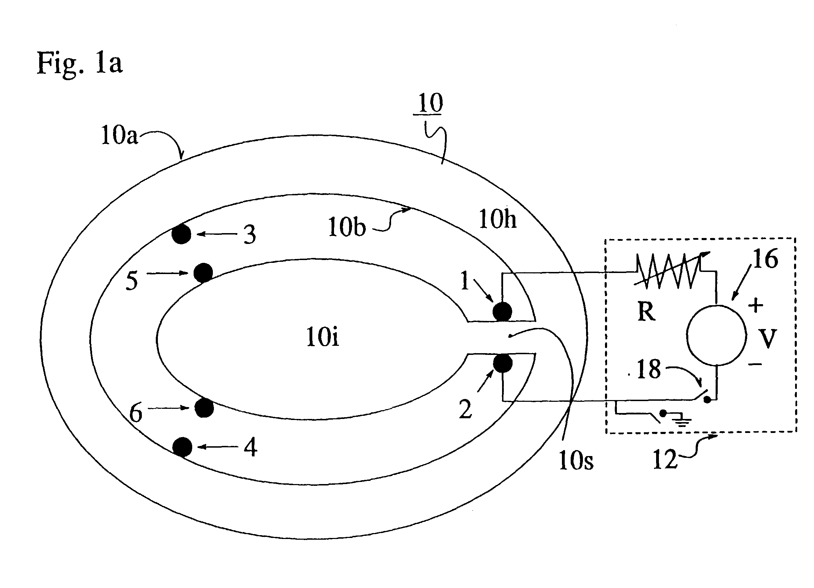

Die in Fig. 1a schematisch dargestellte Halleffekt-Einrichtung enthält ein Hallelement 10, also einen dünnen, praktisch zweidimensionalen Leiter, der ein gebogenes, insbesondere etwa C-förmiges Loch aufweist, das durch einen Innenrand 10b begrenzt ist. Auf das Vorhandensein einer äußeren Begrenzung, also eines Außenrandes 10a kommt es bei diesem Ausführungsbeispiel nicht an. Die "Enden" des C-förmigen Loches begrenzen einen Steg 10s, der den Haupt- oder Außenteil 10h mit einem länglichen, hier ellipsenförmigen Innenteil 10i des Hallelements verbindet. Am Steg 10s ist der Innenrand 10b mit zwei Stromanschlüssen 1, 2 kontaktiert, die mit einer Stromquelle 12 gekoppelt sind. Bei der dargestellten Ausführungsform enthält die Stromquelle eine Spannungsquelle 16, einen dieser in Reihe geschalteten verstellbaren Widerstand R und eine Schaltvorrichtung 18.

Am Innenrand 10b ist ferner im Abstand von den Stromanschlüssen 1, 2 mindestens ein Paar von Hallspannungsanschlüssen 3, 5 und/oder 4, 6 vorgesehen, an denen eine Hallspannung abnehmbar ist. Die Hallspannungsanschlüsse jedes Paares sind so angeordnet, daß ein sie verbindender Stromweg im Hallelement 10 eine die Stromanschlüsse 1, 2 verbindende Linie kreuzt.

Mit der Einrichtung gemäß Figur 1a läßt sich der normale Halleffekt mit scheinbarer Vorzeichenumkehr ohne Kenntnis der Stromverteilung messen. Ein wichtiges Merkmal der Einrichtung gemäß Fig. 1a und vieler anderer erfindungsgemäßer Einrichtungen, die im folgenden noch beschrieben werden, besteht darin, daß der Erregungsstrom (Bias-Strom) in der Nähe der Hallspannungskontakte verschwindet, da er praktisch ausschließlich längs der Verbindungslinie zwischen den Stromanschlüssen 1, 2 quer über den Steg 10s fließt.

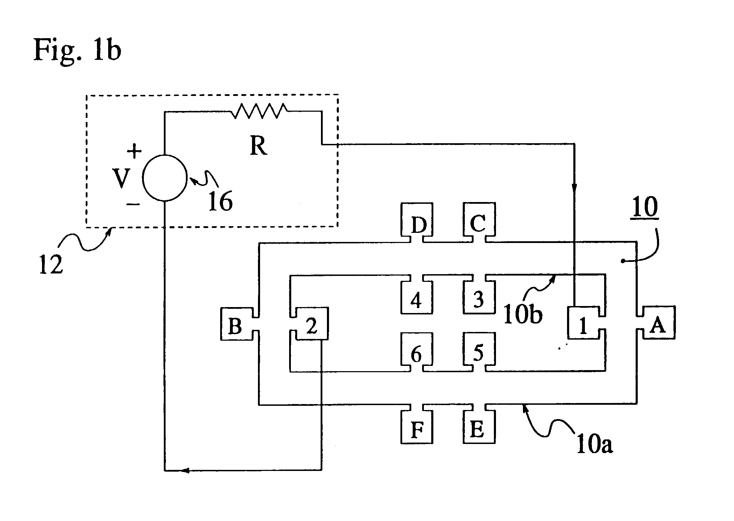

Bei der erfindungsgemäßen Halleffekt-Einrichtung gemäß Fig. 1b hat das Hallelement 10 die Form eines länglichen, rechteckigen Rahmens ("Anti-Hall-Platte"), welcher durch einen äußeren Rand 10a und einen inneren Rand 10b begrenzt ist und streifenförmige Seiten oder Schenkel (zwei kurze, zwei lange) gleicher Breite hat. An zwei einander entgegengesetzten Seiten des inneren Randes 10b sind zwei Stromanschlüsse 1 und 2 angeordnet, die mit einer Stromquelle 12 gekoppelt sind, welche eine Spannungsquelle 16 und einen dieser in Reihe geschalteten Widerstand R enthält. Am inneren Rand 10b ist mindestens ein Paar Hallspannungsanschlüsse (bei dem dargestellten Ausführungsbeispiel zwei Paare von Hallspannungsanschlüssen 3-5 und 4-6) angeordnet, an dem eine Hallspannung entsprechend einem auf das Hallelement einwirkenden Magnetfeld abgenommen werden kann.

Die Breite der streifenförmigen Seiten des rahmenförmigen Hallelements 10 betrug bei einer praktischen Ausführungsform 300 µm, dieser Wert ist selbstverständlich nicht einschränkend auszulegen.

Bei diesen und allen folgenden Ausführungsbeispielen kann anstelle der dargestellten Konfiguration auch irgend eine andere, hinsichtlich des Hall-Effektes topologisch gleichwertige Konfiguration verwendet werden. Auch für die Stromquelle kann jede Einrichtung verwendet werden, die einen geeigneten Gleichstrom, Wechselstrom oder geschalteten Strom, geregelt oder ungeregelt, mit konstanter oder einstellbarer Stärke, zu liefern vermag.

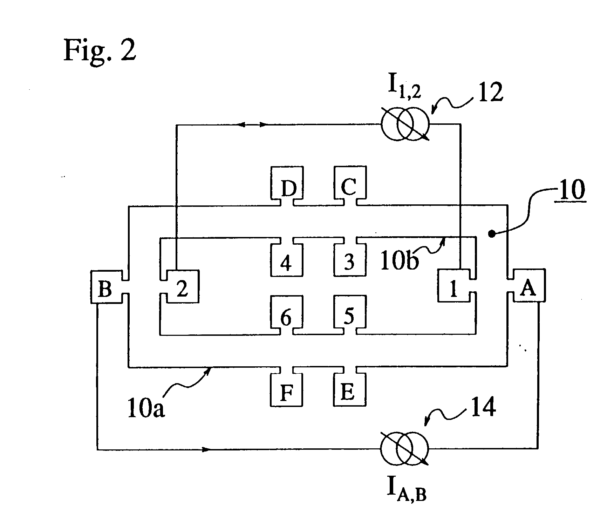

Bei der störspannungskompensierten Halleffekteinrichtung gemäß Fig. 2 sind zusätzlich zu den in Verbindung mit Fig. 1b erwähnten Komponenten auch am äußeren Rand 10a Stromanschlüsse A und B vorgesehen, die mit einer zweiten Stromquelle 14 gekoppelt sind. Außerdem ist am äußeren Rand 10a und/oder am inneren Rand 10b mindestens ein Paar von Hallspannungsanschlüssen C-E und/oder D-F und/oder 3-5 und/oder 4-6 vorgesehen. Die Abstände von einem Stromanschluß zu den Hallspannungsanschlüssen eines Paares sind gleich und groß im Vergleich zum Abstand benachbarter Stromanschlüsse A - 1 bzw. B - 2, dies sind jedoch keine notwendigen Merkmale. Der Strom $I_{1,2}$ bzw. $I_{A,B}$ mindestens einer der beiden Stromquellen 12, 14 ist einstellbar.

Die Hallspannung zwischen den Hallspannungsanschlüssen C-E bzw. D-F hängt hinsichtlich des injizierten Stromes ausschließlich vom Strom $I_{A,B}$ ab. Die Hallspannung zwischen den Hallspannungsanschlüssen 3-5 bzw. 4-6 hängt hinsichtlich des injizierten Stromes ausschließlich vom Strom $I_{1,2}$ ab. Man kann diese beiden Ströme einander überlagern, sodaß die Bereiche in den langen Schenkeln des Hallelements, an deren Rändern die Hallspannungsanschlüsse 3-6 bzw. C-F angebracht sind, praktisch stromlos sind und daher zwischen den zugehörigen Hallspannungsanschlüssen keine strombedingten Fehlerspannungen auftreten können. Der Strom fließt praktisch nur quer durch die kurzen Schenkel und zwar bei diesem Ausführungsbeispiel zwischen den Anschlüssen A und 1 vom Außenrand zum Innenrand während er zwischen den Anschlüssen 2 und B vom Innenrand zum Außenrand fließt.

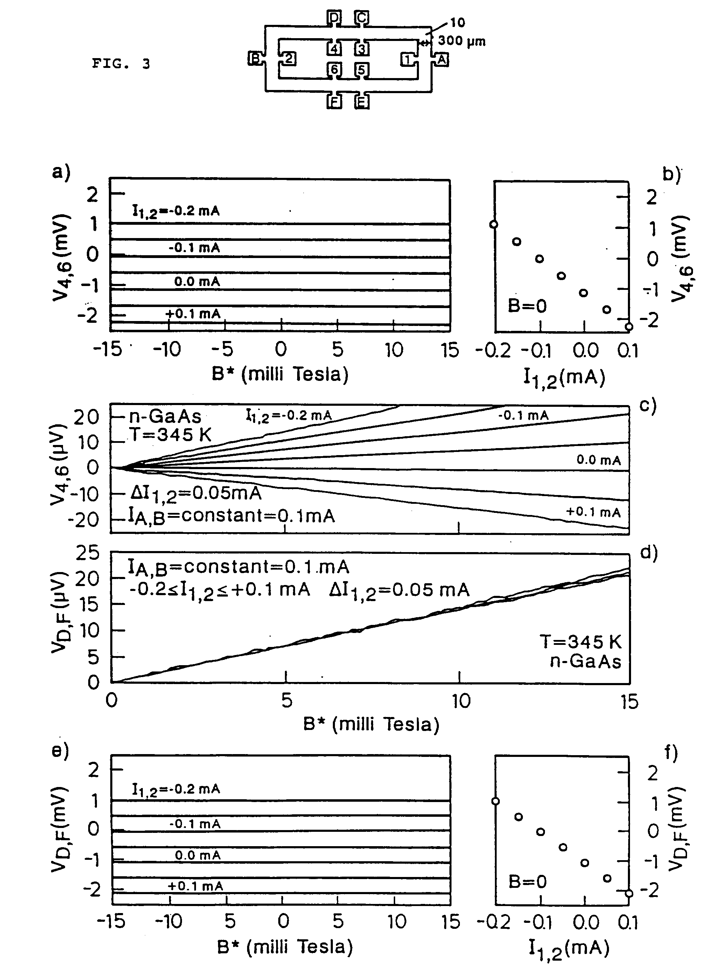

Der Effekt dieser Überlagerung ist in den Diagrammen a) bis f) der Figur 3 dargestellt. Die Messungen wurden mit einem Hallelement der in Fig. 2 dargestellten Konfiguration durchgeführt, das aus einer GaAs-Epischicht bestand ($n_{295K} = 2{,}2 \cdot 10^{17} cm^{-3}$). Der Strom $I_{A,B}$ wurde auf 0,1 mA konstant gehalten.

Diagramm a) zeigt das Hallspannungs-Signal $V_{4,6}$ zwischen den Innenrand-Anschlüssen 4 und 6 in mV in Abhängigkeit von der magnetischen Feldstärke B* in Milli-Tesla, Parameter $I_{1,2}$ in Schritten von 0,05 mA. Man beachte die geringe Neigung, die sich mit $I_{1,2}$ ändert.

Diagramm b) zeigt $V_{4,6}$ in Abhängigkeit von $I_{1,2}$ bei B* = 0. Dieses Signal stellt die durch den Widerstands-Spannungsabfall im Hallelement verursachte Fehlerspannung dar. Man beachte, daß die Fehlerspannung praktisch verschwindet, wenn $I_{1,2} = -I_{A,B} = 0{,}1$ mA ist.

Diagramm 3c) zeigt das fehlerspannungskompensierte Hallspannungssignal

$$dV_{4,6} = (V_{4,6}[+B] - V_{4,6}[-B])/2 \qquad (3)$$

zwischen den Innenrand-Hallspannungsanschlüssen 4 und 6 in Abhängigkeit von B*, Parameter $I_{1,2}$ in Schritten von 0,05mA. Man beachte, daß $dV_{4,6}$ verschwindet, wenn $I_{1,2} = 0$ ist und daß es nur von $I_{1,2}$ proportional abhängig ist. $dV_{4,6}$ ist auch unabhängig von $I_{A,B}$.

Diagramm 3d) zeigt das fehlerspannungskompensierte Hallspannungsignal

$$dV_{D,F} = (V_{D,F}[+B] - V_{D,F}[-B])/2 \qquad (4)$$

zwischen den Außenrand-Hallspannungsanschlüssen D und F. Man beachte, daß $dV_{D,F}$ sich bei Änderungen von $I_{1,2}$ nicht ändert.

Diagramm e) zeigt die Abhängigkeit von $V_{D,F}$ von B*, Parameter $I_{1,2}$ in Schritten von 0,05 mA. Die geringe positive Steigung ist unabhängig von Änderungen des Stromes $I_{1,2}$.

Diagramm f) zeigt die Abhängigkeit von $V_{D,F}$ von $I_{1,2}$ bei B* = 0, d.h. die durch interne Spannungsabfälle verursachte Fehlerspannung am Außenrand des Hallelements 10. Diese Fehlerspannung verschwindet praktisch bei $I_{1,2} = -I_{A,B} = 0,1$ mA wie Diagramm b).

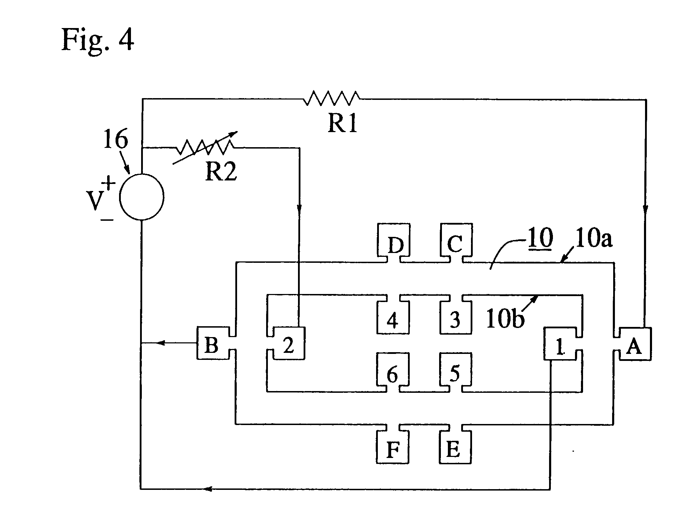

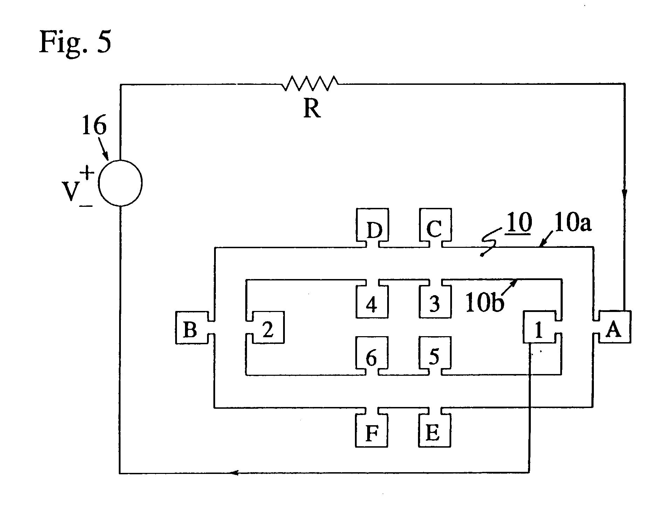

Bei Fig. 2 wurde das Hallelement 10 von zwei getrennten Stromquellen 12, 14 über die Stromanschlüsse A, B und 1, 2 mit Strömen $I_{A,B}$ bzw. $I_{1,2}$ gespeist. Die Figuren 4 und 5 zeigen Ausführungsbeispiele von störspannungsfreien Halleffekt-Einrichtungen gemäß der Erfindung, die nur eine einzige Energiequelle zur Stromversorgung enthalten.

Die Halleffekt-Einrichtung gemäß Fig. 4 enthält eine Energieversorgung mit einer Spannungsquelle 16 und zwei Widerständen R1 und R2, von denen einer, hier R2, veränderbar ist. Der eine Pol der Spannungsquelle 16 ist mit den Stromanschlüssen B und 1 verbunden, während der andere Pol über den Widerstand R1 mit dem Stromanschluß A und über den Widerstand R2 mit dem Stromanschluß 2 gekoppelt ist.

Die Halleffekt-Einrichtung gemäß Fig. 5 enthält zur Energieversorgung eine Spannungsquelle 16 sowie einen Widerstand R, die in Reihe zwischen die Stromanschlüsse 1 und A geschaltet sind. Hier kann an den mit dem Innenrand verbundenen Hallspannungsanschlüssen 3-5 und/oder 4-6 und/oder den mit dem Außenrand verbundenen Hallspannungsanschlüssen C-E und/oder D-F ein Hallspannungssignal abgenommen werden. Ein Hallspannungssignal kann auch zwischen zwei Hallspannungsanschlüssen abgenommen werden, die sich an verschiedenen Rändern befinden, also an jedem der Anschlußpaare C-3, D-4, E-5 und F-6.

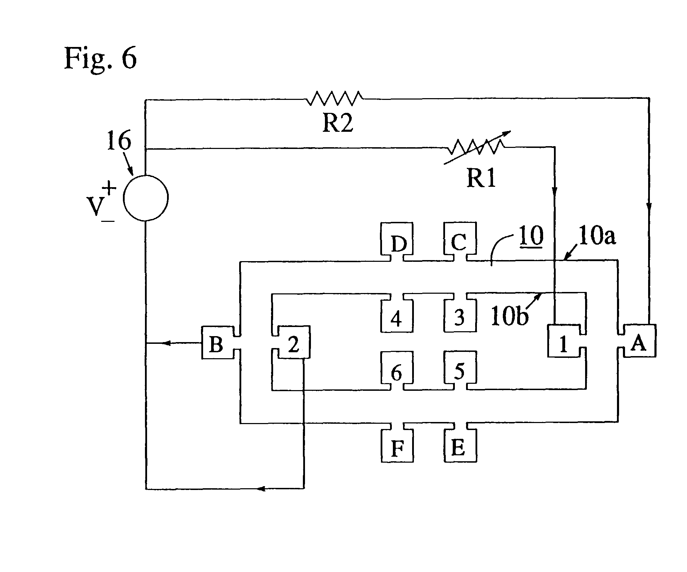

Bei der Ausführungsform gemäß Fig. 6 enthält die Stromversorgungsschaltung eine Spannungsquelle 16 und zwei Widerstände R1, R2. Der eine, hier negative Pol der Spannungsquelle 16 ist mit den Stromanschlüssen B und 2 verbunden. Der andere, positive Pol der Spannungsquelle 16 ist über den Widerstand R1 mit dem Stromanschluß 1 und über den Widerstand R2 mit dem Stromanschluß A verbunden. Im übrigen entsprechen die Halleffekt-Einrichtungen gemäß den Fig. 4 bis 6 denen gemäß Fig. 1 und 2, so daß sich eine weitere Erläuterung erübrigt.

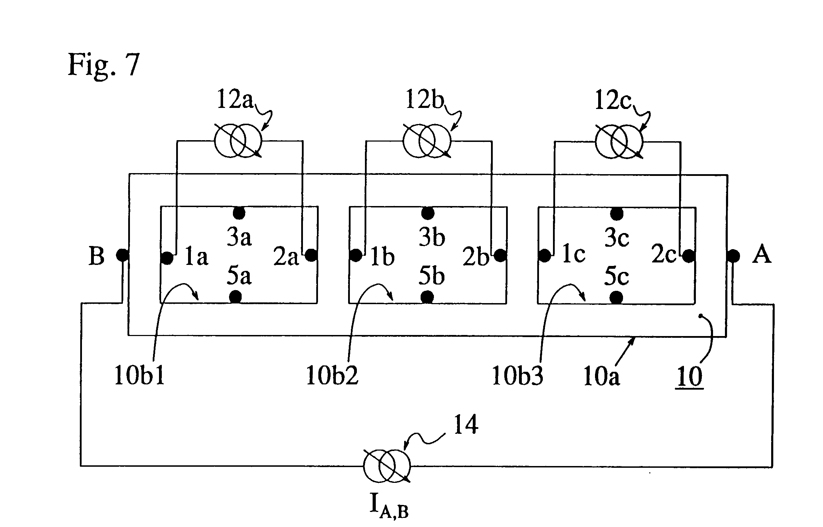

Die Halleffekt-Einrichtung gemäß Fig. 7 hat ein längliches Hallelement mit mehreren, hier drei in einer Reihe angeordneten Löchern oder Fenstern, es hat daher einen Außenrand 10a sowie drei Innenränder 10b1, 10b2, 10b3. An zwei entgegengesetzten Stellen des Außenrandes sind zwei Stromanschlüsse A und B vorgesehen, die mit einer Stromquelle 14 verbunden sind. Die Innenränder sind jeweils mit einem Paar von Stromanschlüssen 1a, 2a bzw. 1b, 2b, bzw. 1c, 2c, die mit zugehörigen, einstellbaren Stromquellen 12a bzw. 12b bzw. 12c gekoppelt sind, und mindestens einem Paar von Hallspannungsanschlüssen 3a, 5a bzw. 3b, 5b bzw 3c, 5c kontaktiert. Die Funktionsweise ist bezüglich jedes Fensters analog der gemäß Fig. 2. Mit dieser Einrichtung läßt sich ein Magnetfeldgradient messen, der längs der Fensterreihe verläuft.

Fig. 7 läßt sich entsprechend den Figuren 4 bis 6 abwandeln und es können auch nur zwei oder mehr als drei Fenster vorgesehen sein und die Fenster können in beliebiger Anordnung im Hallelement verteilt sein.

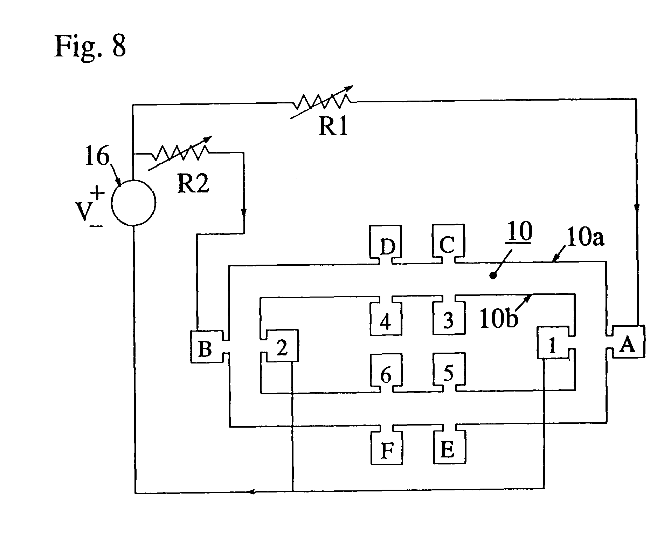

Die Ausführungsform gemäß Fig. 8 ist ähnlich wie die gemäß Fig. 4, mit der Ausnahme, daß der eine Pol der Spannungsquelle 16 über den Widerstand R2 mit dem Stromanschluß B gekoppelt ist, während der Stromanschluß 2 mit dem anderen Pol der Spannungsquelle 16 verbunden ist. Die Ströme fließen hier jedoch beide von den Stromanschlüssen A, B am Außenrand 10a zu dem entsprechenden Stromanschluß 1 bzw. 2 am Innenrand. Diese Einrichtung arbeitet als Magnetfeldgradienten-Detektor. Bei homogenem Magnetfeld tritt keine Hallspannung auf.

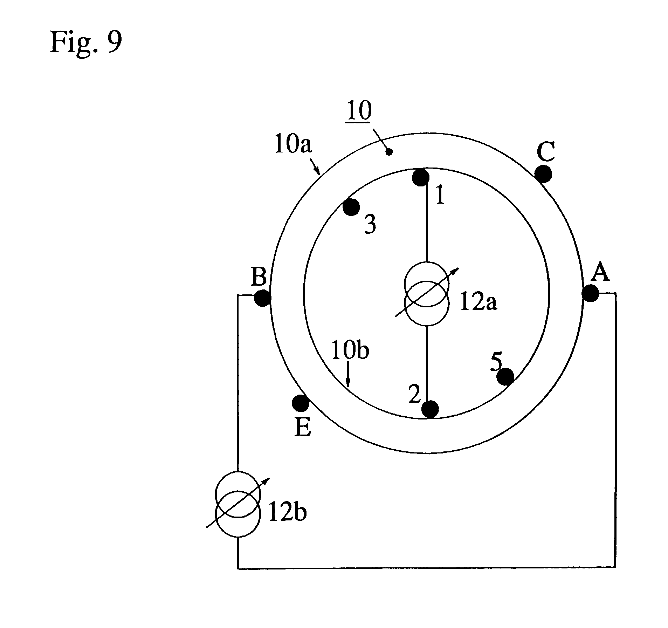

Das Ausführungsbeispiel gemäß Fig. 9 hat ein ringförmiges Hallelement 10, das am Innenrand an zwei diametralen Stellen mit zwei Stromanschlüssen 1, 2 versehen ist, die mit einer Stromquelle 12a gekoppelt sind. An diametralen Stellen des Außenrandes, die bezüglich der Stromanschlüsse 1, 2 um 90° versetzt sind, sind zwei weitere Stromanschlüsse A, B vorgesehen, die mit einer zweiten Stromquelle 12b gekoppelt sind. An diametralen Stellen des Außenrandes, die um 45° bezüglich der Stromanschlüsse versetzt sind, sind zwei Hallspannungsanschlüsse C, E vorgesehen. Ein weiteres Paar 3, 5 von Hallspannungsanschlüssen ist am Innenrand 10b angebracht. Die Hallspannungsanschlüsse 3, 5 sind azimutal bezüglich der Stromanschlüsse 1, 2 versetzt.

Die Einrichtung gemäß Fig. 9 kann wie folgt betrieben werden: Mittels der Stromquelle 12a wird ein konstanter Strom in das Hallelement injiziert. Die Offset-Spannung zwischen den Hallspannungsanschlüssen 3, 5 wird gemessen. Der Strom von der Stromquelle 12a wird dann abgeschaltet. Nun wird mittels der Stromquelle 12b ein Strom über die Anschlüsse A, B in das Hallelement injiziert und der Strom wird solange verändert, bis die Spannung zwischen den Anschlüssen 3, 5 den gleichen Betrag, jedoch das entgegengesetzte Vorzeichen hat wie die vorher gemessene Offset-Spannung. Die Stromquelle 12a wird dann wieder eingeschaltet, so daß sie den gleichen Strom wie beim ersten Einschalten liefert. Die dem Betrag nach gleichen, jedoch entgegengesetzt gepolten Offset-Spannungen heben sich dann zwischen den Anschlüssen 3, 5 auf, so daß die Spannung zwischen den Anschlüssen 3, 5 nur von der Größe eines auf das Hallelement einwirkenden magnetischen Feldes abhängt.

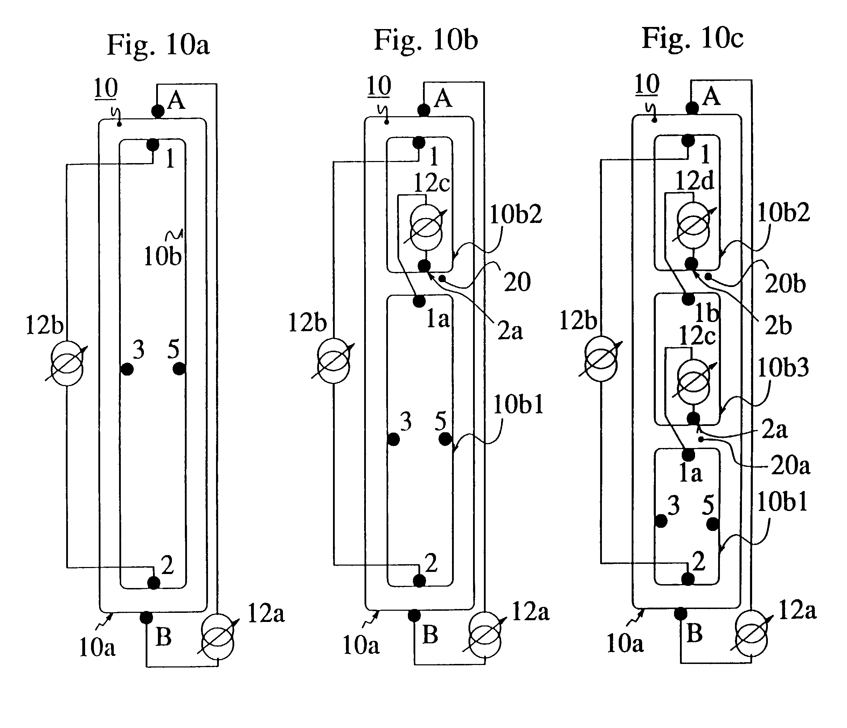

Fig. 10a zeigt eine Halleffekt-Einrichtung des oben anhand von Fig. 2 erläuterten Typs. In den Fig. 10b und 10c ist dargestellt, wie eine solche Halleffekt-Einrichtung modifiziert werden kann.

Die Halleffekt-Einrichtung gemäß Fig. 10b enthält zwei Löcher, die durch einen integralen Steg 20 des Hallelements getrennt sind. Das erste Loch wird durch einen Innenrand 10b1 begrenzt, das zweite Loch durch einen Innenrand 10b2. Der Steg 20 teilt also das einzige Loch der Einrichtung gemäß Fig. 10a zwischen dem Stromanschluß 1 und den Hallspannungsanschlüssen 3, 5 in zwei Löcher auf. Eine dritte Spannungsquelle 12c ist zwischen zwei Stromanschlüsse 1a, 2a geschaltet, die sich auf entgegengesetzten Seiten des Steges 20 am Innenrand 10b1 des einen Loches bzw. am Innenrand 10b2 des anderen Loches befinden.

Fig. 10c zeigt eine Halleffekt-Einrichtung die in zwei Stege 20a, 20b unterteilt ist. Der Steg 20a entspricht dem Steg 20 in Fig. 10b. Der Steg 20b ist wie der Steg 20a mit zwei Stromanschlüssen 1b, 2b versehen, die mit einer vierten Stromquelle 12d gekoppelt sind.

Es ist einleuchtend, daß die Unterteilung durch zusätzliche Stege und Stromquellen beliebig fortgesetzt werden kann. Der Strom aller oder einiger Stromquellen kann veränderbar sein, wie durch einen schrägen Pfeil angedeutet ist. Es können zusätzliche Hallspannungskontakte vorgesehen sein, wie z.B. anhand von Fig. 2 und 7 dargestellt ist. Die Löcher und der Außenrand der Einrichtungen gemäß Fig. 10b und 10c brauchen nicht rechteckig zu sein und die Löcher können mit beliebiger Orientierung im Bezug aufeinander angeordnet sein.

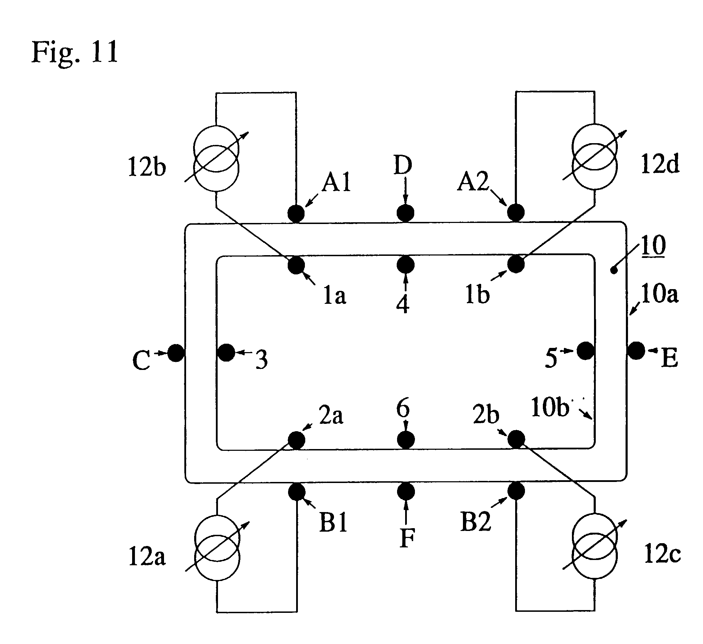

Die in Fig. 11 dargestellte Halleffekt-Einrichtung enthält ein rahmenförmiges Hallelement 10 mit einem Außenrand 10a und einem Innenrand 10b. Zwischen den Außenrand 10a und den Innenrand 10b sind vier Stromquellen 12a, 12b, 12c, 12d geschaltet. Die Stromquelle 12a ist mit Anschlüssen B1 und 2a gekoppelt, die Stromquelle 12b mit Anschlüssen A1 und 1a, die Stromquelle 12c mit Anschlüssen B2 und 2b, und die Stromquelle 12d mit Anschlüssen A2 und 1b. Die Anschlußpaare A1, 1a und A2, 1b befinden sich am einen langen Schenkel des rechteckigen Hallelements 10 und sie haben gleichen Abstand von der Mitte dieses Schenkels, wo sich Hallspannungs-anschlüsse D und 4 befinden. Entsprechendes gilt für die Stromanschlußpaare B1, 2a und B2, 2b bezüglich in der Mitte des anderen langen Schenkels angeordneten Hallspannungs-anschlüsse F und 6. In der Mitte der kurzen Schenkel befinden sich am Innenrand Hallspannungsanschlüsse 3 und 5 sowie am Außenrand Hallspannungsanschlüsse C und E. Bei dieser Einrichtung erfolgt eine differentielle Erzeugung und in-situ Integration des Halleffektes innerhalb eines einzigen Hallelements.

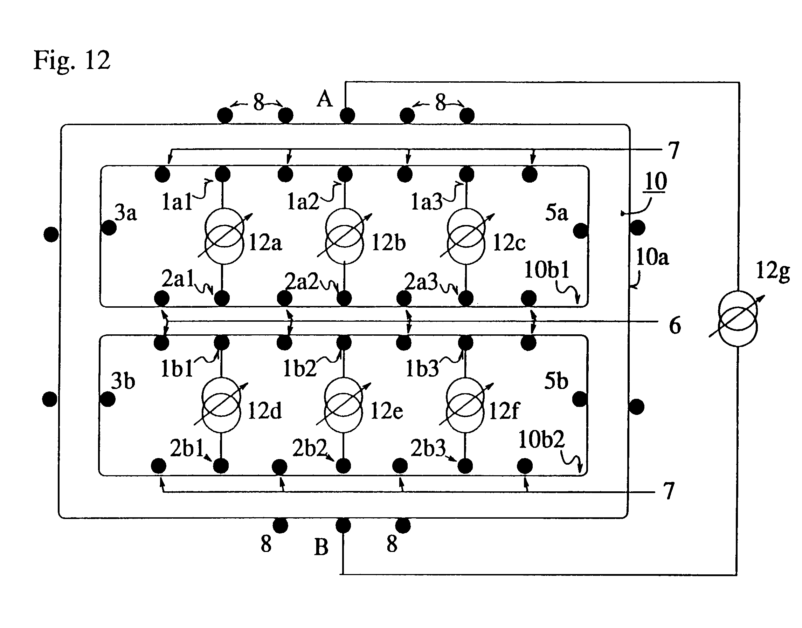

Die Halleffekt-Einrichtung gemäß Fig. 12 hat ein Hallelement 10 mit zwei Löchern, die durch einen Innenrand 10b1 bzw. 10b2 begrenzt sind. Am Innenrand 10b1 des einen Loches sind drei mit Abstand voneinander angeordnete Paare 1a1-2a1, 1a2-2a2 und 1a3-2a3 von Stromkontakten vorgesehen. Jedes Paar ist mit einer Stromquelle 12a, 12b bzw. 12c gekoppelt. In entsprechender Weise sind am Innenrand 10b2 des zweiten Loches drei Paare von Stromanschlüssen 1b1-2b1, 1b2-2b2 und 1b3-2b3 vorgesehen, die mit Stromquellen 12d, 12e bzw. 12f gekoppelt sind. In der Mitte der Schmalseiten der Innenränder der beiden Löcher sind Hallspannungs-Kontakte 3a, 5a bzw. 3b, 5b angebracht. Ferner sind zwischen den Stromanschlüssen und seitlich von diesen an den langen Seiten der Innenränder Hallspannungs-Kontakte 6 und 7 vorgesehen. Am Außenrand 10 sind gegenüber von den Anschlüssen 3a, 3b, 5a und 5b jeweils ein Hallspannungsanschluß vorgesehen. Der Außenrand 10a weist ferner gegenüber von einigen der Innenrand-Anschlüsse 7 zusätzliche Hallspannungsanschlüsse 8 auf. Zwischen zwei Stromanschlüssen A, B am Außenrand 10a ist eine Stromquelle 12g geschaltet.

Auch bei dieser Einrichtung findet wie bei der gemäß Fig. 12 eine differentielle Erzeugung und in-situ Integration der Hallspannung statt. Beispielsweise integriert das Signal zwischen den Hallspannungsanschlüssen 3a, 5a die Hall-spannung, die durch die drei mit dem Innenrand 10b verbundenen Stromquellen erzeugt wird. Dieses Beispiel zeigt auch, daß es nicht erforderlich ist, die Stromquelle oder Stromquellen zwischen Anschlüsse an zwei verschiedenen Rändern des Hallelements zu schalten.

Die Anzahl der Stromanschlußpaare und Stromquellen, die mit dem Innenrand 10b2 des zweiten Loches verbunden sind, kann von der Anzahl der Stromanschlußpaare und Stromquellen, die mit dem Innenrand 10b1 des ersten Loches verbunden sind, verschieden sein.

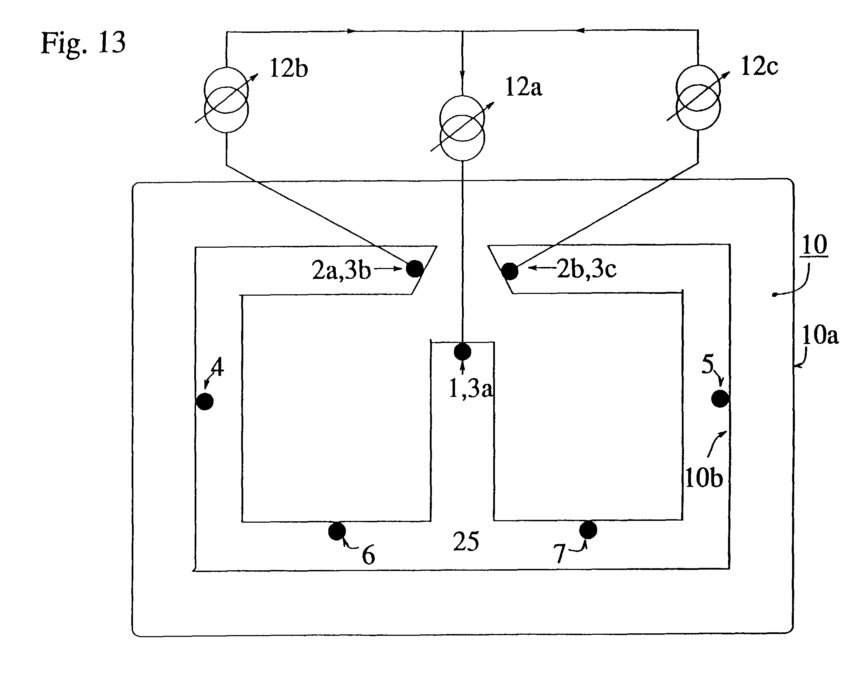

Fig. 13 zeigt ein erstes Beispiel einer Dreipol-HalleffektEinrichtung mit einem Hallelement, das mindestens ein Loch aufweist. Das Hallelement 10 gemäß Fig. 13 hat ein durch einen Innenrand 10b begrenztes Loch 25. Das Loch hat ungefähr die Form eines kopfstehenden "M", dessen äußere Schenkel Ansätze mit schrägen Enden aufweisen, die zum mittleren Schenkel hin vorspringen. An den Enden der Vorsprünge und des mittleren Schenkels ist jeweils einer von drei Stromanschlüssen 1, 2a, 2b angeordnet. Die Stromanschlüsse sind jeweils mit einem Pol einer entsprechenden Stromquelle 12a, 12b bzw. 12c gekoppelt, deren andere Pole miteinander verbunden sind. Am Innenrand 10b kann außerdem eine beliebige Anzahl von Hallspannungsanschlüssen 3a, 3b, 3c, 4-7 vorgesehen sein. Die Hallspannungsanschlüsse 3a, 3b und 3c fallen jeweils mit einem Stromanschluß 1, 2a bzw. 2b zusammen.

Die Einrichtung gemäß Fig. 13 kann wie folgt betrieben werden: Mittels der Stromquelle 12a wird ein Strom vorgegebener Größe in das Hallelement injiziert und von den Stromquellen 12b, 12c aus dem Hallelement aufgenommen. Die Aufteilung des Stromes auf die Stromquellen 12b und 12c wird so eingestellt, daß die Offset-Spannung zwischen zwei Hallspannungsanschlüssen verschwindet. Ein spezielles vorteilhaftes Merkmal dieser Konfiguration ist, daß eine Hall-spannung auch zwischen zwei Stromanschlüssen, z.B. 2a, 2b abgenommen werden kann, die also gleichzeitig Hallspannungs-anschlüsse 3b, 3c bilden. Man beachte, daß im Bereich der Hallspannungsanschlüsse 4-7 praktisch kein Strom fließt. Die z.B. zwischen den Hallspannungsanschlüssen 6 und 7 abgenommene Hallspannung ist daher frei von einer stromabhängigen Offset-Spannung.

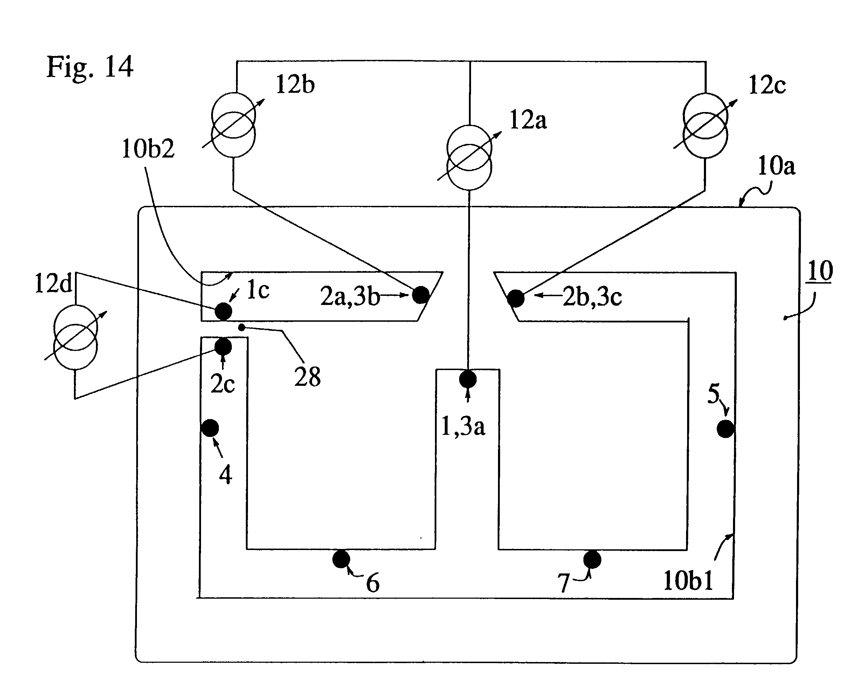

Bei einer Dreipol-Halleffekteinrichtung des anhand von Fig. 13 erläuterten Typs ist es nicht erforderlich, daß sich alle Stromanschlüsse an ein und demselben Rand befinden, wie das Beispiel gemäß Fig. 14 zeigt. Die in Fig. 14 dargstellte Halleffekt-Einrichtung hat eine ähnliche Konfiguration wie die gemäß Fig. 13 mit der Ausnahme, daß das einzige Loch in Fig. 13 am linken Schenkel durch einen Steg 28 in zwei Löcher unterteilt ist. Die Anschlüsse 2a, 3b befinden sich nun am Innenrand 10b2 des zweiten Loches. An entgegengesetzten Seiten des Steges 28 können Anschlüsse 1c, 2c vorgesehen sein, die mit einer vierten Stromquelle 12d gekoppelt sind. Die Arbeitsweise der Einrichtung gemäß Fig. 14 ist dementsprechend ganz analog zu der gemäß Fig. 13.

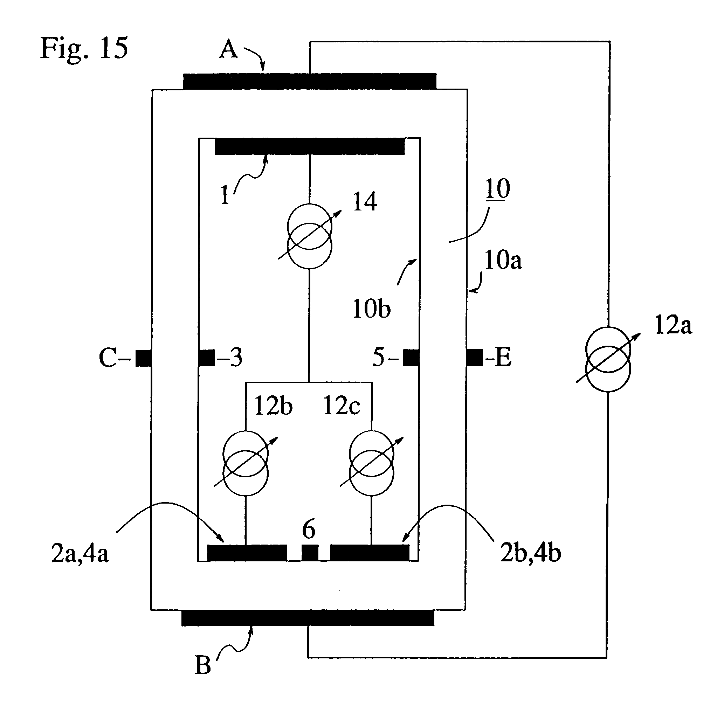

Fig. 15 zeigt eine modifizierte Dreipol-Halleffekt-Einrichtung, die zusätzlich noch Anschlüsse am Außenrand des Hallelements 10 aufweist, das die Form eines rechteckigen Rahmens oder eine topologisch äquivalente Form hat. Zwischen zwei Stromanschlüsse A, B an den Schmalseiten des Außenrandes 10a ist eine erste Stromquelle 12a geschaltet. Eine Anordnung aus drei weiteren Stromquellen 14, 12b und 12c, die der Stromquellenanordnung 12a, 12b und 12c in Fig. 13 entspricht, ist zwischen einen Stromanschluß 1, der am Innenrand 12b dem Stromanschluß A gegenüberliegt und Stromanschlüsse 2a, 2b, die am Innenrand 10b dem Stromanschluß B gegenüberliegen, geschaltet. Am Außen- und Innenrand sind ferner Hallspannungsanschlüsse C, E, 3, 4a, 4b, 5, 6 vorgesehen. Man beachte, daß die Hallspannungsanschlüsse 4a und 4b durch die Stromanschlüsse 2a bzw. 2b gebildet werden.

Auch hier werden die Stromquellen 12a-12c und 14 so eingestellt, daß der Strom in den Längsschenkeln der Einrichtung verschwindet. Ein Vorteil dieser Konfiguration besteht darin, daß man durch geeignete Einstellung der relativen Größen der Drain-Ströme der Stromquellen 12b und 12c die restliche Offset-Spannung an den Hallspannungsanschlüssen C, E sowie 3, 5 besonders gut kompensieren kann.

Die Anschlüsse A, B, 1, 2a und 4b nehmen bei dem Ausführungsbeispiel gemäß Fig. 15 einen relativ großen Bereich des jeweiligen Randes ein.

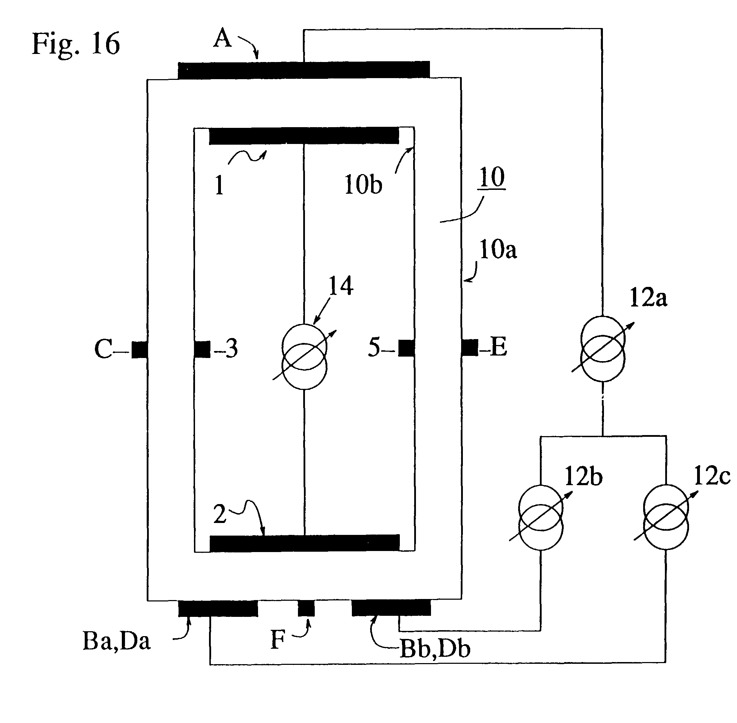

Fig. 16 zeigt eine Halleffekt-Einrichtung, die zur Halleffekt-Einrichtung gemäß Fig. 5 sozusagen invers ist, d.h. daß eine aus drei Stromquellen 12a, 12b und 12c bestehende Stromquellenanordnung (Split-Drain-Konfiguration) mit dem Außenrand 10a verbunden ist. Die Anordnung gemäß Fig. 16 kann wie die gemäß Fig.

15 betrieben werden.

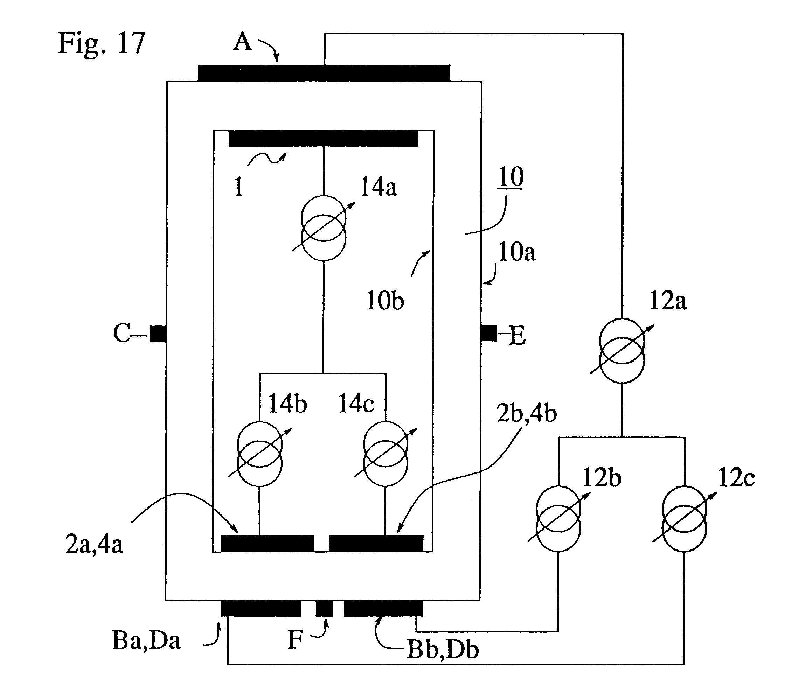

Die Halleffekt-Einrichtung gemäß Fig. 17 ist eine Kombination der Einrichtungen gemäß Fig. 15 und 16, d.h. daß sowohl mit dem Außenrand 10a als auch mit dem Innenrand 10b eine Dreipol-Stromquellenanordnung 12a, 12b, 12c bzw. 14a, 14b, 14c gekoppelt ist. Die Stromquellen 12b und 12c sind mit Anschlüssen Ba, Bb an der Schmalseite des Außenrandes gekoppelt, diese Anschlüssen können auch als Hallspannungs-anschlüsse Da, Db verwendet werden.

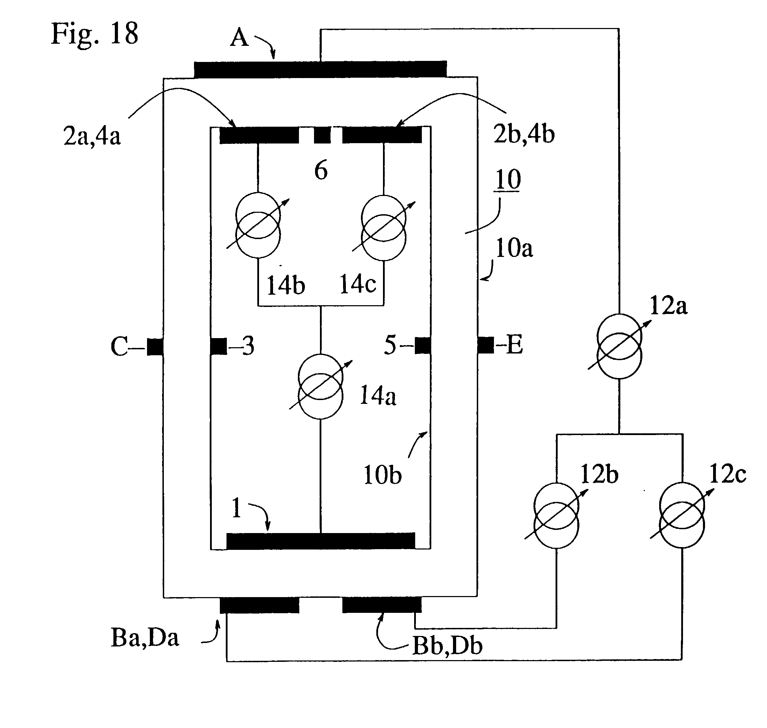

Bei Fig. 17 sind zwei Drain-Stromquellen 12b, 12c bzw. 14b, 14c mit dem gleichen kurzen Schenkel des rechteckigen Hallelements gekoppelt. Die Source-Stromquellen 12a, 14a sind mit dem anderen kurzen Schenkel gekoppelt. Bei Fig. 18 sind die Drain-Stromquellen dagegen mit entgegengesetzten schmalen Schenkeln verbunden.

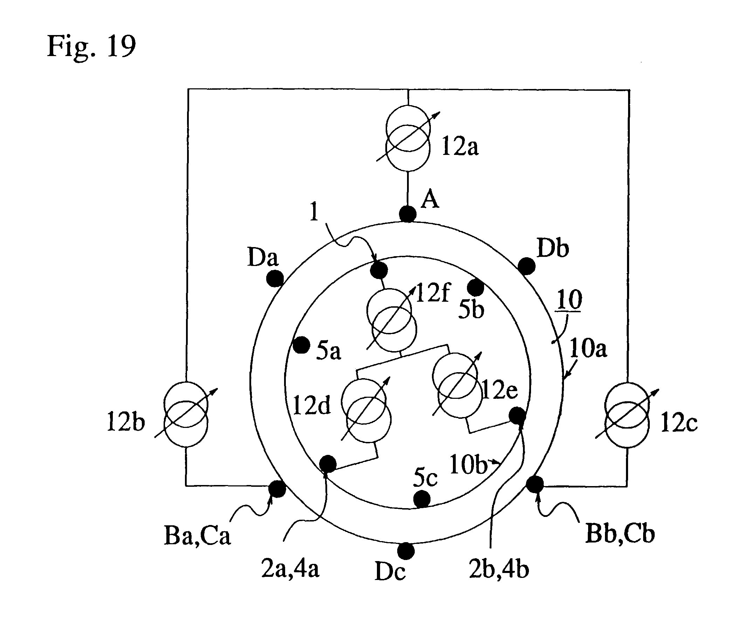

Fig. 19 zeigt eine Einrichtung, die ähnlich aufgebaut ist wie die gemäß Fig. 18. Das Hallelement 10 ist jedoch ringförmig, die Stromquellen 12a, 12b und 12c sind mit in Bezug aufeinander um 120° versetzten Anschlüssen A, Ba, Bb am Außenrand des Hallelements gekoppelt, während die Stromquellen 12e, 12f und 12d mit drei Anschlüssen 1, 2a, 2b des Innenrandes 10b gekoppelt sind, die Winkelabstände von 120° voneinander haben können und um einen beliebigen Winkel bezüglich der stromanschlüsse am Außenrand versetzt sein können. Im übrigen entspricht diese Einrichtung der gemäß Fig. 18.

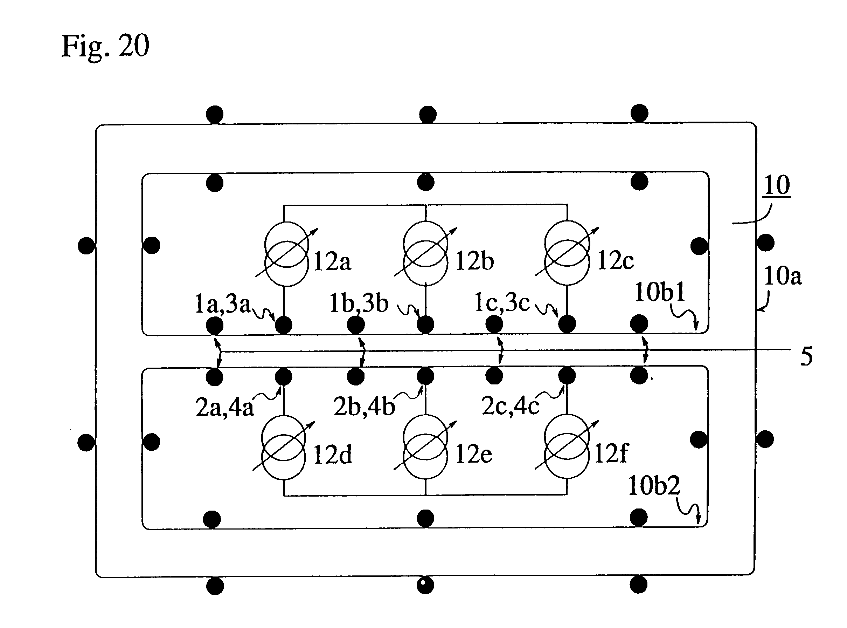

Fig. 20 zeigt eine Halleffekt-Einrichtung, deren Hallelement 10 zwei Löcher hat, die durch einen Innenrand 10bl bzw. 10b2 begrenzt sind. Mit jedem Innenrand ist eine Dreipol-Stromquellenanordnung 12a, 12b, 12c bzw. 12d, 12e, 12f des oben beschriebenen Typs gekoppelt. Eine Hallspannung kann u.a. an den mit 5 bezeichneten Anschlußpaaren abgenommen werden. Die Dreipol-Stromquellen sind mit Anschlüssen gekoppelt, die sich an dem die beiden Löcher trennenden Steg, also einander gegenüber, befinden. Die Einrichtung gemäß Fig. 20 arbeitet analog zu den Einrichtungen gemäß Fig. 17-19.

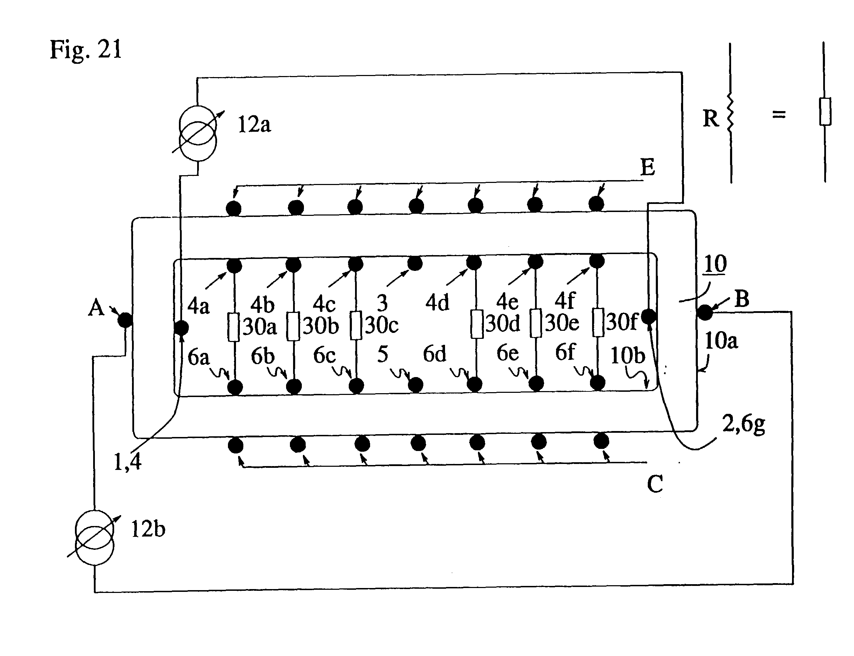

Fig. 21 zeigt eine Halleffekt-Einrichtung mit einem rechteckigen Hallelement 10, das ein Loch mit einem Innenrand 10b hat. Eine erste Stromquelle 12a ist mit Anschlüssen 1, 2 an einander entgegengesetzten Stellen der kurzen Seiten des Innenrandes gekoppelt. Eine zweite Stromquelle 12b ist mit Anschlüssen A, B an einander entgegengesetzten Stellen der Schmalseiten des Außenrandes 10a gekoppelt. An einander gegenüberliegenden Stellen 4a-6a, 4b-6b, ... 4f-6f des Innenrandes 10b sind Hallspannungsanschlüsse vorgesehen, die jeweils durch einen Widerstand 30a, 30b, ... bzw. 30f miteinander gekoppelt sind. Die Widerstände können gleiche oder verschiedene Werte haben. Die Ströme der Stromquellen 12a, 12b werden so eingestellt, daß der Strom im Bereich der Anschlüsse 3, 5 und C, E verschwindet. Ein Vorteil dieser Ausführungsform besteht darin, daß zwischen sukzessiven Anschlüssen, wie 4a, 4f eine Hallspannung abgenommen werden kann, die bezüglich einer Feldumkehr symmetrisch ist und im wesentlichen frei von Offset-Spannungsstörungen ist.

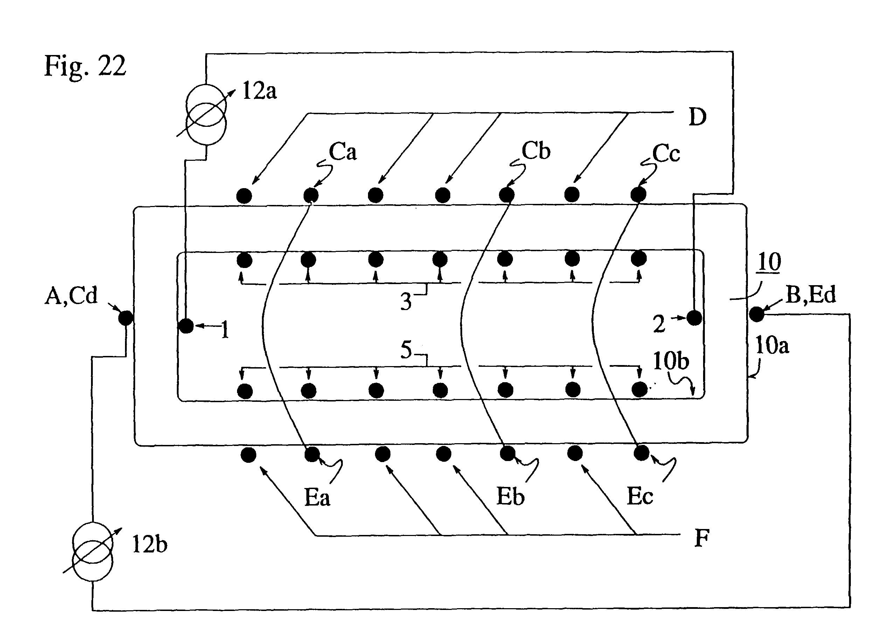

Die Einrichtung gemäß Fig. 22 enthält ein rahmenförmiges Hallelement 10 mit einem Außenrand 10 und einem durch einen Innenrand 10b begrenzten Loch. An entgegengesetzten Stellen der langen Seiten des Außenrandes sind Hallspannungs-Kontakte Ca, Cb, Cc, D, Ea, Eb, Ec und F vorgesehen. An gegenüberliegenden Stellen des Innenrandes befinden sich Hallspannungskontakte 3 bzw. 5. Mindestens ein Paar, bei dem dargestellten Ausführungsbeispiel drei Paare Ca-Ea, Cb-Eb, Cc-Ec von Hallspannungs-Kontakten des Außenrandes sind galvanisch verbunden, z.B. über einen Widerstand (nicht dargestellt) wie bei Fig. 21 oder, wie dargestellt, durch eine Kurzschlußbrücke. Die Einrichtung arbeitet wie die gemäß Fig. 21.

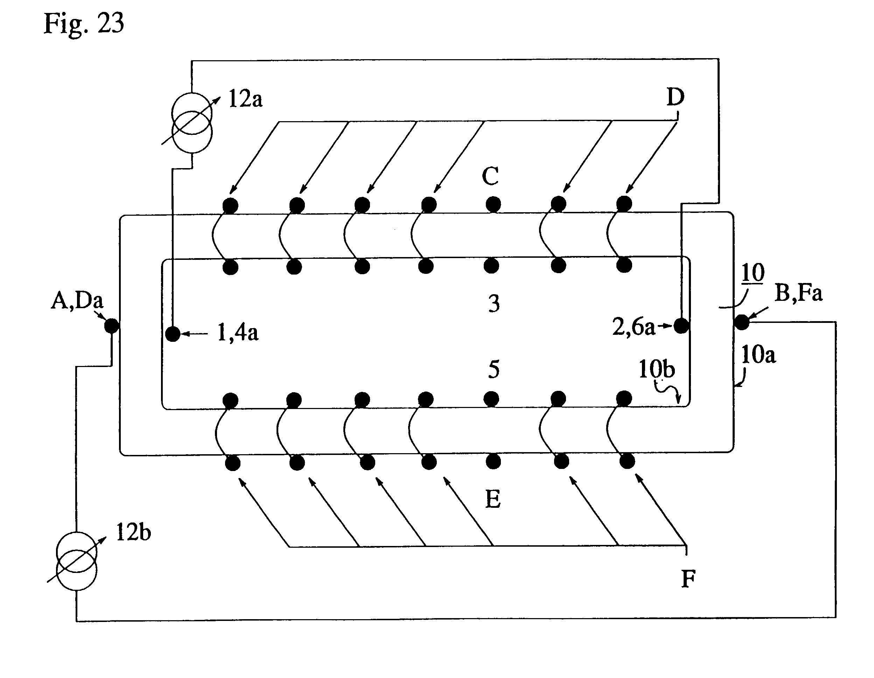

Fig. 23 zeigt eine Halleffekt-Einrichtung, die ähnlich aufgebaut ist wie die gemäß Fig. 22, nur sind hier ein oder mehrere Paare von einander gegenüberliegenden Hallspannungs-Kontakten am Außen- und Innenrand desselben Schenkels galvanisch, z.B. über jeweils einen Widerstand oder, wie dargestellt, durch eine Kurzschlußbrücke miteinander verbunden. Diese Einrichtung kann zum Vergleich der Ströme verwendet werden, die am Außenrand bzw. Innenrand injiziert werden.

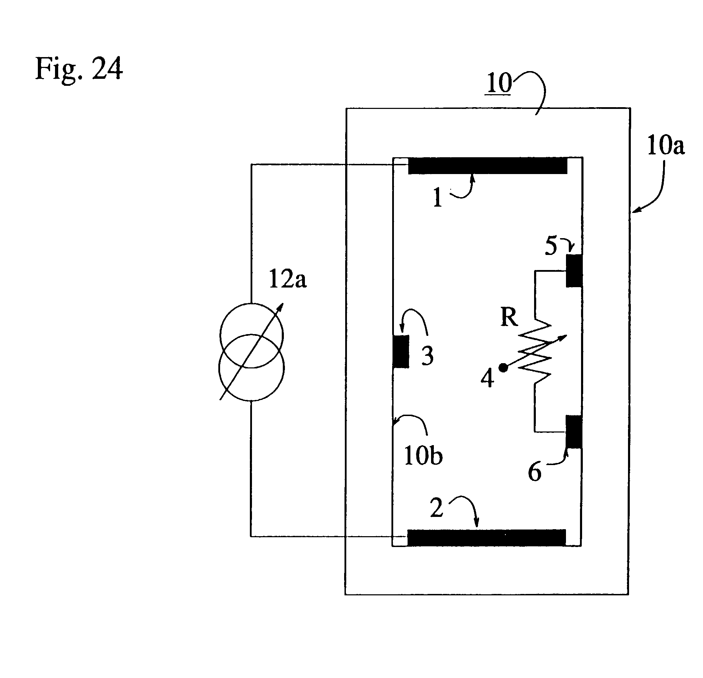

Fig. 24 zeigt eine Halleffekt-Einrichtung mit einem Hallelement 10, das ein durch einen Innenrand 10b begrenztes Loch aufweist. Auf den Außenrand 10a kommt es hier nicht an. An entgegengesetzten, ausgedehnten Stellen der Schmalseiten des Innenrandes sind Stromanschlüsse 1, 2 angebracht, die mit einer Stromquelle 12a verbunden sind. In der Mitte der einen langen Seite des Innenrandes ist ein erster Hallspanungsanschluß 3 angebracht. An der gegenüberliegenden langen Seite sind im wesentlichen symmetrisch zur Mitte zwei Anschlüsse 5, 6 angebracht. Die Anschlüsse 5, 6 sind mit den Enden des Widerstandes eines Potentiometers R verbunden. Eine magnetfeldabhängige Hallspannung wird zwischen dem Anschluß 3 und dem Schleifer 4 des Potentiometers abgenommen. Der Schleifer wird so eingestellt, daß die stromabhängige Offset-Spannung verschwindet. Die Aufteilung eines Hallspannungsanschlusses in zwei Anschlüsse 5, 6 und die Abnahme der Hallspannung über ein Potentiometer kann auch bei den anderen Ausführungsformen Anwendungen finden.

Die beschriebenen Ausführungsformen lassen sich in der verschiedensten Weise abwandeln, z.B. durch Kombination verschiedener Merkmale verschiedener Ausführungsbeispiele. Als Halbleitermaterial für das Hallelement können auch andere Materialien verwendet werden, als sie oben erwähnt wurden, z.B. $A_{II}B_{VI}$-Halbleiterverbindungen.

Zur Erhöhung der Empfindlichkeit kann das Hallelement mit einem weichmagnetischen Material beschichtet sein und/oder ein supraleitfähiges Material enthalten.

**Patentansprüche**

1. Halleffekt-Einrichtung mit einem Hallelement [10], das mit Stromanschlüssen und mit Hallspannungsanschlüssen, an denen bei Einwirkung eines Magnetfeldes auf das Hallelement eine Hall-Spannung auftritt, versehen ist, **dadurch gekennzeichnet, daß** das Hallelement mindestens ein Loch aufweist, das durch einen inneren Rand [10b] begrenzt ist und daß mindestens einer der genannten Anschlüsse an diesem inneren Rand angeordnet ist.

2. Halleffekt-Einrichtung nach Anspruch 1, **dadurch gekennzeichnet,** daß am inneren Rand [10b] mindestens ein Stromanschluß [1 und/oder 2] sowie mindestens ein Paar von Hallspannungsanschlüssen [3, 4; 5, 6] angeordnet sind.

3. Halleffekt-Einrichtung nach Anspruch 1, **gekennzeichnet durch**

    - ein im wesentlichen C-förmiges Loch mit einem inneren Rand [10b], der einen stegartigen Bereich [10s] des Hallelements [10] begrenzt,
    - zwei Stromanschlüsse [1, 2] am stegartigen Bereich [10s] und
    - mindestens zwei Hallspannungsanschlüsse [3, 4; 5, 6] am inneren Rand.

4. Halleffekt-Einrichtung nach Anspruch 1, **dadurch gekennzeichnet**, daß

    - das Hallelement [10] außerdem durch einen äußeren Rand [10a] begrenzt ist,
    - ein erstes Paar von Stromanschlüssen [A, B] an zwei entgegengesetzten Stellen des äußeren Randes angeordnet ist,
    - ein zweites Paar von Stromanschlüssen [1, 2] an zwei entgegengesetzten Stellen des inneren Randes [10b] angeordnet sind;
    - mindestens ein erstes Paar von Hallspannungsanschlüssen [3, 5] an zwei entgegengesetzten Stellen des inneren Randes zwischen den Stromanschlüssen [1, 2] des zweiten Paares angeordnet sind.

5. Halleffekt-Einrichtung nach Anspruch 4, **gekennzeichnet durch** mindestens ein zweites Paar von Hallspanungsanschlüssen [C, E] an zwei entgegengesetzten Stellen des äußeren Randes [10a] zwischen den Stromanschlüssen [A, B] des ersten Paares.

6. Halleffekt-Einrichtung nach Anspruch 4, **dadurch gekennzeichnet,** daß mit den Stromanschlüssen [A, B] des ersten Paares eine erste Stromquelle [14; 16, R1] gekoppelt ist und daß mit den Stromanschlüssen des zweiten Paares [1, 2] eine zweite Stromquelle [12; 16, R2] gekoppelt ist, wobei die Polaritäten und Größen der von den Stromquellen gelieferten Ströme so bemessen sind, daß durch Spannungsabfall am Hallelement verursachte Fehlerspannungen an den Hallspannungsanschlüssen verringert werden.

7. Halleffekt-Einrichtung nach Anspruch 6, **dadurch gekennzeichnet,** daß die Stromquellen [12, 14] so gepolt sind, daß der Strom jeweils zwischen einem Stromanschluß [A, B] am äußeren Rand [10a] zum benachbarten Stromanschluß [1 bzw. 2] am inneren Rand [10b] fließt.

8. Halleffekt-Einrichtung nach Anspruch 6, **dadurch gekennzeichnet,** daß die Stromquellen [16, R1, R2] so gepolt sind, daß der Strom von einander benachbarten Stromanschlüssen [1, A] des ersten und zweiten Paares zu den anderen einander benachbarten Stromanschlüssen [B, 2] fließt.

9. Halleffekt-Einrichtung nach Anspruch 1, gekennzeichnet durch

   - mindestens zwei Löcher, die durch einen stegartigen Bereich [20, 20a, 20b] des Hallelements getrennt sind,
   - zwei Stromanschlüsse [1a, 2a; 1b, 2b] an entgegengesetzten Seiten des stegartigen Bereiches, und
   - eine mit diesen Stromanschlüssen gekoppelte Stromquelle [12c, 12d].

10. Halleffekt-Einrichtung nach Anspruch 9, **gekennzeichnet durch** eine weitere Stromquelle [12a], die mit Stromanschlüssen [A, B] an einem Außenrand des Hallelements angeordnet sind.

11. Halleffekt-Einrichtung nach Anspruch 9 oder 10, **gekennzeichnet durch** eine Stromquelle [12b], die mit einem ersten und einem zweiten Stromanschluß [1, 2] am Innenrand [10b2, 10b1] eines ersten und eines zweiten Loches gekoppelt ist.

12. Halleffekt-Einrichtung nach Anspruch 2, **dadurch gekennzeichnet,** daß

   - das Hallelement [10] die Form eines durch einen Außenrand [10a] und einen Innenrand [10b] begrenzten Rahmens hat;
   - an mehreren, bezüglich des rahmenförmigen Hallelements symmetrischen Stellen jeweils ein Paar von Stromanschlüssen [A1, 1a; B1, 2a; A2, 1b; B2, 2b] an einander gegenüberliegenden Stellen des Außen- und Innenrandes angeordnet sind und
   - im Abstand von den Stromanschlüssen am Außen- und Innenrand mindestens ein Paar von Hallspannungsanschlüssen [C, 3; D, 4; E, 5; F, 6] vorgesehen ist.

13. Halleffekt-Einrichtung nach Anspruch 1, **dadurch gekennzeichnet,** daß

   - das Hallelement mindestens ein erstes Loch, das durch einen ersten Innenrand [10b1] begrenzt ist und mindestens ein zweites Loch, das durch einen zweiten Innenrand [10b2] begrenzt ist, aufweist;
   - an mindestens einem Paar einander entgegengesetzten Stellen des ersten Innenrandes ein Paar von Stromanschlüssen [1a1, 2a1] angeordnet ist,
   - daß zwischen jedes Paar dieser Stromanschlüsse eine Stromquelle [12a, ...] geschaltet ist;
   - daß an mindestens zwei einander entgegengesetzten Stellen des zweiten Innenrandes [10b2] ein Paar von zweiten Stromanschlüssen [1b1, 2b1] angebracht ist;
   - jedes Paar zweiter Stromanschlüsse mit einer Stromquelle [12d, ...] gekoppelt ist und
   - daß an jedem Innenrand mindestens ein Paar von Hallspannungsanschlüssen [6, 7] angebracht ist.

14. Halleffekt-Einrichtung nach Anspruch 13, **dadurch gekennzeichnet,** daß eine weitere Stromquelle [12g] mit zwei Stromanschlüssen [A, B] an einem Außenrand [10a] des Hallelements gekoppelt ist.

15. Halleffekt-Einrichtung nach Anspruch 1, **dadurch gekennzeichnet,** daß

   - das mindestenes eine Loch drei Schenkel aufweist, an deren Enden jeweils ein Stromkontakt [1, 2a, 2b] angeordnet ist;
   - daß die drei Stromkontakte mit einer Stromquellenanordnung [12a, 12b, 12c] gekoppelt ist, die einen Quellenanschluß und zwei Senkenanschlüsse hat; und
   - am Innenrand des Loches mindestens ein Paar von Hallspannungsanschlüssen angeordnet ist.

16. Halleffekt-Einrichtung nach Anspruch 15, **dadurch gekennzeichnet,** daß mindestens ein Schenkel des Loches durch einen Steg [28] unterteilt ist.

17. Halleffekt-Einrichtung nach Anspruch 16, **dadurch gekennzeichnet,** daß der Steg durch eine Stromquelle [12d] überbrückt ist.

18. Halleffekt-Einrichtung nach Anspruch 1, **dadurch gekennzeichnet,** daß eine dreipolige Stromquellenanordnung [12b, 12c, 12d] mit drei Stromanschlüssen [1, 2a, 2b] am Innenrand [10b] des mindestens eines Loches gekoppelt ist.

19. Halleffekt-Einrichtung nach Anspruch 1 oder 18, **dadurch gekennzeichnet,** daß mit einem Außenrand [10a] des Hallelements eine dreipolige Stromquellenanordnung über drei Stromanschlüsse [A, Ba, Bb] gekoppelt ist.

20. Halleffekt-Einrichtung nach einem der vorhergehenden Ansprüche 1 bis 19, **dadurch gekennzeichnet,** daß mindestens ein Paar von Hallspannungsanschlüssen durch eine gleichstromleitende Verbindung überbrückt ist.

21. Halleffekt-Einrichtung nach einem der vorhergehenden Ansprüche, **dadurch gekennzeichnet,** daß mindestens ein Hallspannungsanschluß eines Paares durch einen Abgriff [4] eines Potentiometers [R] gebildet ist, dessen Enden mit zwei im Abstand voneinander an einem Rand des Hallelements angebrachten Anschlüssen [5, 6] verbunden sind.

22. Halleffekt-Einrichtung nach einem der vorhergehenden Ansprüche, **dadurch gekennzeichnet,** daß das Hallelement einen Außen- und einen Innenrand aufweist, die im wesentlichen gleichen Abstand voneinander aufweisen.

## Claims

1. A Hall-effect device having a Hall element (10) provided with current connections and with Hall voltage connections at which when the Hall element is subjected to the effect of a magnetic field a Hall voltage occurs, characterized in that the Hall element has at least one hole bounded by an inner edge (10b) and at least one of said connections is arranged at the inner edge.

2. Hall-effect device according to claim 1, characterized in that at the inner edge (10b) at least one current connection (1 and/or 2) and at least one pair of Hall voltage connections (3, 4, 5, 6) are arranged.

3. Hall-effect device according to claim 1, characterized by

   - a substantially C-shaped hole with an inner edge (10b) bounding a web-like region (10s) of the Hall element,
   - two current connections (1, 2) at the web-like region (10s), and
   - at least two Hall voltage connections (3, 4, 5, 6) at the inner edge.

4. Hall-effect device according to claim 1, characterized in that

   - the Hall element (10) is additionally bounded by an outer edge (10a),
   - a first pair of current connections (A, B) is arranged at two opposed locations of said outer edge,
   - a second pair of current connections (1, 2) is arranged at two opposed locations of said inner edge (10b),
   - at least a first pair of Hall voltage connections (3, 5) is arranged at two opposed locations of the inner edge between the current connections (1, 2) of the second pair.

5. Hall-effect device according to claim 4, characterized by at least a second pair of Hall voltage connections (C, E) at two opposed locations of the outer edge (10a) between the current connections (A, B) of the first pair.

6. Hall-effect device according to claim 4, characterized in that a first current source (14, 16, R1) is coupled to the current connections (A, B) of the first pair and a second current source (12, 16, R2) ist coupled to the current connections of the second pair (1, 2) the polarities and magnitudes of the currents supplied by the current sources being dimensioned so that misalignment voltages resulting due to a voltage drop at the Hall element are reduced at the Hall voltage connections.

7. Hall-effect device according to claim 6, characterized in that the current sources (12, 14) are poled so that the current flows between a current connection (A, B) at the outer edge (10a) to the neighbouring current connection (1 or 2) at the inner edge (10b), respectively.

8. Hall-effect device according to claim 6, characterized in that the current sources (16, R1, R2) are poled so that the current flows from the neighbouring current connections (1, A) of the first and second pair to the other neighbouring current connections (B, 2).

9. Hall-effect device according to claim 1, characterized in by

   - at least two holes separated by a web-like region (20, 20a, 20b) of the Hall element,
   - two current connections (1a, 2a; 1b, 2b) at opposite sides of the web-like region, and
   - a current source (12c, 12d) being coupled to the current connections.

10. Hall-effect device according to claim 9, characterized by a further current source (12a) being arranged with current connections (A, B) at an outer edge of the Hall element.

11. Hall-effect device according to claim 9 or 10, characterized by a current source (12b) being coupled to a first and to a second current connection (1, 2) at the inner edge (10b2, 10b1) of a first and of a second hole.

12. Hall-effect device according to claim 2, characterized in that

   - the Hall element (10) has the shape of a frame bounded by an outer edge (10a) and by an inner edge (10b),
   - a pair of current connections (A1, 1a; B1, 2a; A2, 1b; B2, 2b) is provided at each of several locations symmetrical with respect to the frame-shaped Hall element at opposing locations of the outer and the inner edge, and
   - at least one pair of Hall voltage connections (C, 3; D, 4; E, 5; F, 6) is provided separated from the current connections on the outer and inner edge.

13. Hall-effect device according to claim 1, characterized in that

   - the Hall element has at least one first hole bounded by a first inner edge (10b1) and at least one second hole bounded by a second inner edge (10b2),
   - a pair of current connections (1a1, 2a1) is arranged at at least one pair of opposed locations on the first inner edge;
   - a current source (12a, ...) is connected between each pair of the current connections;
   - a pair of second current connections (1b1, 2b1) is arranged at at least two opposed locations on the second inner edge (10b2) ;
   - each pair of the second current connections is coupled to a current source (12d, ...), and
   - at least one pair of Hall voltage connections (6, 7) is provided at each inner edge.

14. Hall-effect device according to claim 13, characterized in that a further current source (12g) with two current connections (A, B) is coupled to an outer edge (10a) of the Hall element.

15. Hall-effect device according to claim 1, characterized in that

   - the at least one hole has three legs at each end of which being arranged a current contact (1, 2a, 2b) ;
   - the three current contacts are coupled to a current source arrangement (12a, 12b, 12c) having a source connection and two drain connections; and
   - at the inner edge of the hole at least one pair of Hall voltage connections is provided.

16. Hall-effect device according to claim 15, characterized in that at least one leg of the hole is divided by a web (28).

17. Hall-effect device according to claim 16, characterized in that the web is short-circuited by a current source (12d).

18. Hall-effect device according to claim 1, characterized in that a three-terminal current source arrangement (12b, 12c, 12d) having three current connections (1, 2a, 2b) is coupled to the inner edge (10b) of the at least one hole.

19. Hall-effect device according to claim 1 or 18, characterized in that a three-terminal current source arrangement is coupled via three connections (A, Ba, Bb) to an outer edge (10a) of the Hall element.

20. Hall-effect device according to one of the foregoing claims 1 to 19 characterized in that at least one pair of Hall voltage connections is short-circuited by a direct current conducting connection.

21. Hall-effect device according to one of the foregoing claims characterized in that at least one Hall voltage connection of a pair is formed by a tap (4) of a potentiometer (R), the ends of which being connected to two connections (5, 6) provided by an edge of the Hall element.

22. Hall-effect device according to one of the foregoing claims, characterized in that the Hall-element has an outer and an inner edge having substantially an equal distance from each other.

**Revendications**

1. Dispositif à effet Hall comportant un élément à effet Hall (10) qui est pourvu de points de raccordement de courant et de points de raccordement de tension Hall auxquels apparaît une tension Hall sous l'action d'un champ magnétique appliqué à l'élément à effet Hall (10), caractérisé en ce que l'élément à effet Hall (10) présente au moins un trou qui est délimité par un bord interne (10b) et en ce qu'au moins un des points de raccordement précités est situé sur ce bord interne.

2. Dispositif à effet Hall suivant la revendication 1 caractérisé en ce que sur le bord interne (10b) sont situés au moins un point de raccordement de courant (1 et/ou 2) ainsi qu'au moins une paire de points de raccordement de tension Hall (3,4;5,6).

3.  Dispositif à effet Hall suivant la revendication 1 caractérisé en ce qu'il comporte un trou sensiblement en forme de C ayant un bord interne (10b) qui délimite un domaine en forme de branche ou traverse (10s) de l'élément à effet Hall (10), deux points de raccordement de courant (1,2) sur le domaine en forme de branche (10s) et au moins deux points de raccordement de tension Hall (3,4;5,6) sur le bord interne.

4.  Dispositif à effet Hall suivant la revendication 1 caractérisé en ce que l'élément à effet Hall (10) est en outre délimité par un bord externe (10a), une première paire de points de raccordement de courant (A,B) sont situés en deux emplacements opposés du bord externe, une seconde paire de points de raccordement de courant (1,2) sont situés en deux emplacements opposés du bord interne (10b) et au moins une première paire de points de raccordement de tension Hall (3,5) sont situés en deux emplacements opposés du bord interne, entre les points de raccordement de courant (1,2) de la seconde paire.

5.  Dispositif à effet Hall suivant la revendication 4 caractérisé en ce qu'il comporte au moins une seconde paire de points de raccordement de tension Hall (C,E) situés en deux emplacements opposés du bord externe (10a) entre les points de raccordement de courant (A,B).

6.  Dispositif à effet Hall suivant la revendication 4 caractérisé en ce qu'une première source de courant (14;16,R1) est reliée aux points de raccordement de courant (A,B) de la première paire et une seconde source de courant (12;16,R2) est reliée aux points de raccordement de courant (1,2) de la seconde paire, les polarités et les grandeurs des courants fournis par les sources de courant étant déterminées de telle façon que des tensions d'erreur produites dans l'élément à effet Hall (10) par une chute de tension soient réduites à l'endroit des points de raccordement de tension Hall.

7.  Dispositif à effet Hall suivant la revendication 6 caractérisé en ce que les sources de courant (12,14) sont polarisées de telle façon que le courant s'écoule chaque fois entre un point de raccordement de courant (A,B) situé sur le bord externe (10a) en direction d'un point de raccordement de courant voisin (1 ou 2) situé sur le bord interne (10b).

8.  Dispositif à effet Hall suivant la revendication 6 caractérisé en ce que les sources de courant (16,R1,R2) sont polarisées de telle façon que le courant s'écoule à partir de points de raccordement de courant (1,A), voisins l'un de l'autre, de la première et de la seconde paire en direction des autres points de raccordement de courant (B,2) voisins l'un de l'autre.

9.  Dispositif à effet Hall suivant la revendication 1 caractérisé en ce qu'il comporte au moins deux trous qui sont séparés par un domaine en forme de branche ou traverse (20,20a,20b) de l'élément à effet Hall, deux points de raccordement de courant (1a, 2a;1b,2b) situés sur les côtés opposés du domaine en forme de branche ou traverse et une source de courant (12c,12d) reliée à ces points de raccordement de courant.

10. Dispositif à effet Hall suivant la revendication 9 caractérisé en ce qu'il comporte une source de courant additionnelle (12a) qui est reliée à des points de raccordement de courant (A,B) situés sur un bord externe de l'élément à effet Hall.

11. Dispositif à effet Hall suivant l'une quelconque des revendications 9 ou 10 caractérisé en ce qu'il comporte une source de courant (12b) qui est reliée à des premier et second points de raccordement de courant (1,2) situés sur un bord interne (10b2, 10b1) de premier et second trous.

12. Dispositif à effet Hall suivant la revendication 2 caractérisé en ce que l'élément à effet Hall (10) a la forme d'un cadre délimité par un bord externe (10a) et un bord interne (10b), en ce qu'en chacun de plusieurs emplacements symétriques par rapport à l'élément à effet Hall en forme de cadre est disposée une paire de points de raccordement de courant (A1,1a;B1,2a;A2,1b;B2,2b) qui sont situés en des emplacements opposés l'un à l'autre sur le bord externe et sur le bord interne et en ce qu'au moins une paire de points de raccordement de tension Hall (C,3;D,4;E,5;F,6) est prévue, sur les bords externe et interne, à distance des points de raccordement de courant.

13. Dispositif à effet Hall suivant la revendication 1 caractérisé en ce que l'élément à effet Hall comporte au moins un premier trou qui est délimité par un premier bord interne (10b1) et au moins un second trou qui est délimité par un second bord interne (10b2), une paire de points de raccordement de courant (1a1,2a1) est située à l'endroit d'au moins une paire d'emplacements, opposés l'un à l'autre, du premier bord interne, une source de courant (12a, ...) est branchée entre chaque paire de ces points de raccordement de courant, une paire de seconds points de raccordement de courant (1b1,2b1) est disposée à l'endroit d'au moins deux emplacements, opposés l'un à l'autre, sur le second bord interne (10b2), une source de courant (12d, ...) est reliée à chaque paire de seconds points de raccordement de courant, et au moins une paire de points de raccordement de tension Hall (6,7) est située sur chaque bord interne.

14. Dispositif à effet Hall suivant la revendication 13 caractérisé en ce qu'une borne de courant additionnelle (12g) est reliée à deux points de raccordement de courant (A,B) situés sur un bord externe (10a) de l'élément à effet Hall.

15. Dispositif à effet Hall suivant la revendication 1 caractérisé en ce qu'il comporte au moins un trou présentant trois ailes et à chaque extrémité de chacune de ces ailes est disposé un contact de courant (1,2a,2b), en ce que les trois contacts de courant sont reliés à un ensemble de sources de courant (12a,12b,12c) qui présente un point de raccordement source et deux points de raccordement drains, et en ce qu'au moins une paire de points de raccordement de tension Hall est située sur le bord interne du trou.

16. Dispositif à effet Hall suivant la revendication 15 caractérisé en ce qu'au moins une aile du trou est séparée par une branche ou traverse (28).

17. Dispositif à effet Hall suivant la revendication 16 caractérisé en ce que la branche ou traverse est shuntée par une source de courant (12d).

18. Dispositif à effet Hall suivant la revendication 1 caractérisé en ce qu'un ensemble de sources de courant à trois pôles (12b,12c,12d) est relié à trois points de raccordement de courant (1,2a,2b) situés sur le bord interne (10b) d'au moins un trou.

19. Dispositif à effet Hall suivant l'une quelconque des revendications 1 ou 18 caractérisé en ce qu'un ensemble de sources de courant à trois pôles est relié au bord externe (10a) de l'élément à effet Hall par l'intermédiaire de trois points de raccordement de courant (A,Ba,Bb).

20. Dispositif à effet Hall suivant l'une quelconque des revendications 1 à 19 caractérisé en ce qu'au moins une paire de points de raccordement de tension Hall est shuntée par une liaison à courant continu.

21. Dispositif à effet Hall suivant l'une quelconque des revendications précédentes caractérisé en ce qu'au moins un point de raccordement de tension Hall d'une paire de tels points de raccordement est constituée par un curseur (4) d'un potentiomètre (R) dont les extrémités sont reliées à deux points de raccordement (5,6) situés, à distance l'un de l'autre, sur un bord de l'élément à effet Hall.

22. Dispositif à effet Hall suivant l'une quelconque des revendications précédentes caractérisé en ce que l'élément à effet Hall présente un bord externe et un bord interne qui sont situés sensiblement à la même distance l'un de l'autre.

Fig. 1a

Fig. 1b

EP 0 689 723 B1

Fig. 2

$I_{1,2}$   12

D   C

10

4   3   10b

B   2   1   A

6   5

10a

F   E   14

$I_{A,B}$

EP 0 689 723 B1

16

FIG. 3

Fig. 4

R1

R2

16

V $\overset{+}{-}$

10 10a

10b

A

B

C

D

E

F

1

2

3

4

5

6

Fig. 5

EP 0 689 723 B1

Fig. 6

Fig. 7

Fig. 8

EP 0 689 723 B1

EP 0 689 723 B1

Fig. 9

Fig. 10a

Fig. 10b

Fig. 10c

Fig. 11

EP 0 689 723 B1

Fig. 12

EP 0 689 723 B1

Fig. 13

12b

12a

12c

2a,3b →

← 2b,3c

10

10a

4

1,3a

5

10b

6

25

7

EP 0 689 723 B1

Fig. 14

12b   12c   12a

10b2   10a

10

12d   1c   2a,3b   2b,3c

28

2c

5

4

1,3a

6   7   10b1

EP 0 689 723 B1

Fig. 15

C—    —3          5—    —E

12b   12c

6

2a,4a          2b,4b

B

A

1

10

10a

10b

14

12a

EP 0 689 723 B1

Fig. 16

EP 0 689 723 B1

Fig. 17

Fig. 18

EP 0 689 723 B1

Fig. 19

Fig. 20

EP 0 689 723 B1

Fig. 21

EP 0 689 723 B1

Fig. 22

Fig. 23

EP 0 689 723 B1

Fig. 24

EP 0 689 723 B1